# EUROPÄISCHE PATENTSCHRIFT

(11) **EP 2 148 939 B1**
(45) Veröffentlichungstag und Bekanntmachung des Hinweises auf die Patenterteilung: **14.06.2017**
(21) Anmeldenummer: 08736455.0
(22) Anmeldetag: 22.04.2008
(51) Int. Cl.: C23C 14/32, C23C 16/02, C23C 16/503, H01J 37/32

(54) **VAKUUMBEHANDLUNGSANLAGE UND VAKUUMBEHANDLUNGSVERFAHREN**
VACUUM TREATMENT UNIT AND VACUUM TREATMENT PROCESS
INSTALLATION ET PROCÉDÉ DE TRAITEMENT SOUS VIDE

(30) Priorität: 25.05.2007 CH 8432007
(43) Veröffentlichungstag der Anmeldung: 03.02.2010
(73) Patentinhaber: Oerlikon Surface Solutions AG, Pfäffikon, 8808 Pfäffikon (CH)
(72) Erfinder: RAMM, Jürgen, CH-7304 Maienfeld (CH); WIDRIG, Beno, CH-7310 Bad Ragaz (CH); KASEMANN, Stephan, A-6800 Feldkirch (AT); PIMENTA, Marcelo, Dornelles, CH-7320 Sargans (CH); MASSLER, Orlaw, CH-9492 Eschen (LI); HANSELMANN, Barbara, CH-9479 Oberschan (CH)
(74) Vertreter: Troesch Scheidegger Werner AG
(86) Internationale Anmeldenummer: PCT/EP2008/054851
(87) Internationale Veröffentlichungsnummer: WO 2008/145459

(56) Entgegenhaltungen:
- WO-A-02/06554
- DE-A1- 3 941 202
- DE-A1- 19 826 259
- DE-C1- 19 841 012
- US-B1- 6 391 164

## Beschreibung

### Technisches Gebiet

Die Erfindung betrifft eine Vakuumbehandlungsanlage nach dem Oberbegriff von Anspruch 1 bzw. ein Vakuumbehandlungsverfahren nach dem Oberbegriff von Anspruch 22 für die Plasmabehandlung von Werkstücken.

### Stand der Technik

Unter den Vakuumbehandlungsverfahren nehmen heute plasmaunterstützte Verfahren zum Beschichten, Heizen und Ätzen unterschiedlicher Werkstücke, wie zum Beispiel Werkzeuge oder Komponenten im Bereich des Maschinen- und Motorenbaus einen breiten Raum ein. Häufig werden dabei dem Vakuumbeschichtungsverfahren Heiz- und/oder Ätzprozesse vorgeschaltet, die für spezielle Anwendungen, beispielsweise zur Vorreinigung, Oberflächenaktivierung oder Entschichtung auch alleine zur Anwendung kommen.

Trotz der weiten Verbreitung oben genannter Verfahren ist es auch heute noch schwierig bzw. aufwendig solche Verfahren zu betreiben, wenn während eines Verfahrensschrittes Isolierbelegungen und/oder schlecht leitende bzw. isolierende Schichten auf den Elektrodenoberflächen abgeschieden werden. Solche Schichten können beispielsweise durch Oberflächen- bzw. Resputtereffekte während des Heiz- und Ätzprozesses, insbesondere aber bei Vakuumbeschichtungsverfahren zur Abscheidung von schlecht leitenden bzw. isolierenden Schichten auf den Elektrodenflächen gebildet werden. Beispiele solcher schlecht leitender oder isolierender Schichten sind keramische oder metallkeramische Schichten, wie unten näher beschrieben.

Eine Sonderstellung nehmen DLC-artige Schichten unter denen im Folgenden Schichten wie in VDI 2840, Tabelle 1, Spalte "2 amorphe Kohlenstoffschichten" angeführt verstanden werden. Diese können je nach Abscheideverfahren elektrisch mehr oder weniger leitfähig oder sogar isolierend hergestellt werden.

Es gibt verschiedene Verfahren, um kohlenstoff- oder kohlenstoffhaltige Schichten auf Werkzeugen und Bauteilen abzuscheiden. Üblicherweise teilt man die Herstellungsverfahren im Vakuum danach ein, ob die schichtbildenden Bestandteile über ein Gas in das Vakuumbeschichtungssystem eingelassen und anschliessend im Plasma zersetzt werden (CVD), oder ob die Überführung eines schichtbildenden Feststoffes in die Dampfphase direkt im Vakuumsystem erfolgt (PVD). Bei den PVD Verfahren sind vor allem Verdampfungsprozesse mittels Elektronenstrahl, Sputtern von Kohlenstofftargets und das kathodische Verdampfen mittels Funkenverdampfung bekannt. Der auf diese Weise verdampfte Kohlenstoff besteht aus Atomen, Ionen oder Clustern von im wesentlichen elementaren Kohlenstoff. Im Gegensatz dazu werden als Kohlenstoffquellen im CVD-Prozess typischerweise kohlenwasserstoffhaltige Gase verwendet wie beispielsweise C₂H₂, C₂H₄ oder CH₄. Die Trennung des Kohlenstoffs vom Wasserstoff erfolgt dabei durch eine Dissoziation im Plasma oder durch eine hohe Substrattemperatur, die zur Dissoziation des Reaktivgases, auch Precursor genannt, an der Substratoberfläche führt. Da die hohe Substrattemperatur bei der Abscheidung von diamantähnlichen Schichten auf temperaturempfindlichen Werkstücken meist unerwünscht ist, wird eine effiziente Zerlegung des Precursors im Plasma angestrebt. Um ein unnötiges Aufheizen des Werkstückes zu vermeiden ist es auch wünschenswert, die Zerlegung des Precursors möglichst getrennt vor dem Abscheideprozess am Werkstück durchzuführen. Dadurch können am Werkstück die Schichteigenschaften beispielsweise über den Energieeintrag der schichtbildenden Ionen durch Einstellung einer bestimmten Substratspannung, Prozessdruck usw. besser und ohne die Gefahr einer Überhitzung eingestellt werden.

Diese Anforderungen können nicht durch eine Diodenentladung wie sie unter anderem in DE 19513614 beschrieben ist realisiert werden, da hier die Werkstücke bzw. Werkstücke als eine Elektrode dieser Entladung dienen und die Dissoziationsbedingungen nicht von den Bedingungen der Substratspannung getrennt werden können.

Die Zerlegung gasförmiger Precursor in einer Diodenentladung hat zusammengefasst folgende wesentlichen Nachteile. Die Substrate dienen als eine Elektrode der Glimmentladung was dazu führt, dass die Beladungsmenge und die Werkstückgeometrie die Entladung, die Gasdissoziation und damit die Schichteigenschaften selbst beeinflussen. Das ist unerwünscht, da im industriellen Beschichtungsbetrieb unterschiedliche Beladungen und unterschiedliche Werkstückgeometrien behandelt werden müssen. Ausserdem erschwert diese Abhängigkeit von Beladung und Substratgeometrie die Vorausschaubarkeit von Prozessen, was einen grossen zusätzlichen Aufwand bei der Prozessentwicklung bedeutet.

Ein weiterer wichtiger Nachteil von Diodenglimmentladungen ist ihre geringe Plasmadichte, wodurch es nicht möglich ist gasförmige Precursor effizient, d.h. möglichst vollständig zu zerlegen. Daher werden hohe Gasflüsse benötigt, um wirtschaftliche Beschichtungsraten zu erzielen. Durch den resultierenden höheren Druck wächst die Gefahr von Gasphasenreaktionen und Staubbildung.

In einer verbesserten Diodenentladung, wie in WO2006-116889 beschrieben, werden Werkstückhalterungen oder Vorrichtungen zur passiven Verstärkung des Plasmas geometrisch so gestaltet, dass es unter den Prozessbedingungen zu einer Ausbildung von Hohlkathodenentladungen kommt, die zu einer zusätzlichen Dissoziation des Precursors führen. Nachteilig ist hier aber, dass diese Hohlkathodenentladungen in unmittelbarer Werkstücknähe zu einer Substraterwärmung führen und vor allem, dass sie den jeweiligen Druck- und Substratspannungsverhältnissen angepasst werden müssen, um ein zuverlässiges Zünden und Betreiben zu gewährleisten. Das führt zu grossem Aufwand beim Design der jeweiligen Werkstückhalterungen für verschiedene Werkstückformen und zu Einschränkungen in der Parameterwahl des Abscheideprozesses, so dass beispielsweise nur eine verhältnismässig kleine Beschichtungsrate eingestellt werden kann, um die Werkstücke nicht thermisch zu überlasten.

Das ist der Grund dafür, dass es schon seit einigen Jahren Bestrebungen gibt, um, wie schon oben erwähnt, das Plasma, das zur Dissoziation des gasförmigen Precursors dienen soll, vom Energieeintrag am Werkstück zu trennen.

In DE 36 143 84 wird eine Niedervoltbogenentladung (NVBE) offenbart, die zwischen einer Heisskathode in einer separaten Kathodenkammer und einer Anode betrieben wird. Die gasförmigen Precursor werden im Niedervoltbogen aktiviert, ionisiert und separat davon wird eine Gleichspannung an die Werkstücke gelegt, um die Ionenenergie am Werkstück einstellen zu können. In dieser Schrift wird der Anregungsbereich des zugeführten Gases vom Wachstumsbereich an den Werkstücken getrennt. Das Verfahren besitzt allerdings zwei entscheidende Nachteile, die dazu geführt haben, dass es sich nicht in allen Fällen industriell ausnutzen lässt, besonders dann nicht, wenn man schlecht leitende oder isolierende Schichten abscheiden möchte. Dabei kommt es einerseits zu isolierenden Schichten am Werkstück, die dazu führen, dass der Ionenbeschuss aus dem Plasma abnimmt, weil der Gleichspannungsbias ab einer bestimmten Schichtdicke nicht mehr wirksam ist. Andererseits kommt es dazu, dass sich die Anode der Niedervoltbogenentladung ebenfalls mit einer isolierenden Schicht belegt, die zu einem Anstieg der Entladespannung und schliesslich zu Instabilitäten des Bogens und zum Abbruch der DC Niedervoltbogenentladung führt. Obwohl in diese Beschreibung die Abscheidung von harten Kohlenstoff-, also DLC-artigen Schichten beschrieben wird, konnte sich dieses Verfahren auf Grund der oben beschriebenen Schwierigkeiten industriell bis heute nicht durchsetzen.

EP 0990061 offenbart ganz allgemein die Vorteile einer elektrischen Trennung der Anregung des Reaktivgases und der Einstellung der Substratspannung am Werkstück. Dabei wird eine bipolare Substratspannung verwendet, weil hochisolierende Schichten realisiert werden sollen.

In EP 0430872 wird gezeigt, wie eine unipolar gepulste Substratspannung in Verbindung mit einer Niedervoltbogenentladung verwendet werden kann, um isolierende Schichten wie Oxide und Nitride, die einen noch höheren elektrischen Widerstand als die harten Kohlenstoffschichten aufweisen, auf einem Werkstück abzuscheiden. In diesem Verfahren ist die Anode der DC-Niedervoltbogenentladung ein gekühlter Tiegel, aus dem die Metallkomponente des schichtbildenden Materials durch eben diese Niedervoltbogenentladung verdampft wird.

Obwohl eine pulsierende Substratspannung in Kombination mit dem unabhängigen Plasma, das durch den Niedervoltbogen erzeugt und gespeist wird, ausreicht, um die Oberflächen von isolierenden Schichten über den Elektronenbeschuss aus dem NVBE-Plasma wieder zu entladen, sind auch Verfahren bekannt, die am Werkstück mit bipolarer Substratspannung und veränderlichen Pulsen arbeiten. Ein solches Verfahren wird beispielsweise von Griepentrog in Surface & Coatings Technology Vol.74-75(1995), S.326-332, beschrieben.

In EP 0990061 wird analog zu DE 36 143 84 eine Vorrichtung und ein PECVD Verfahren beschrieben, das auf zwei voneinander unabhängig betriebenen Entladungen beruht, wobei im Unterschied zu Griepentrog eine veränderliche Substratspannung verwendet wird.

WO02/06554 offenbart eine Graphitanode mit einer BN-Abdeckung.

Mittlerweile hat sich gezeigt, dass DLC-artige, insbesondere harte wasserstofffreie Schichten mit hohem tetragonalen Schichtanteil und daraus resultierenden besonders guten Verschleisseigenschaften elektrisch hoch isolierend sind. Um diese Eigenschaften zu erzielen, ist unter anderem auch eine niedrige Substrattemperatur entscheidend. Weiters hat sich erwiesen, dass die Benutzung eines DC Niedervoltbogens eine sehr effiziente Methode ist, um die gasförmigen Precursor zu zerlegen. Allerdings hat sich auch gezeigt, dass sich die üblicherweise gekühlte metallische Anode der Niedervoltbogenentladung innerhalb kurzer Zeit mit einer isolierenden Schicht belegt, was vor allem bei längeren Beschichtungszeiten zu Prozessinstabilitäten führt.

### Darstellung der Erfindung

Der Erfindung liegt die Aufgabe zu Grunde, eine Vakuumbehandlungsanlage nach dem Oberbegriff von Anspruch 1 bzw. ein Vakuumbehandlungsverfahren nach dem Oberbegriff von Anspruch 22 zur Verfügung zu stellen, mit denen es möglich ist eine Plasmabehandlung von Werkstücken unter verschiedenen Bedingungen, insbesondere aber auch dann sicher reproduzierbar und produktiv durchzuführen, wenn bei Betreiben einer Niedervoltbogenentladung mit herkömmlichen Anlagen bzw. Verfahren die Gefahr der Ausbildung einer Isolierbelegung, insbesondere einer isolierenden Schicht auf der Anodenoberfläche besteht. Durch solche Isolierbelegungen, die beispielweise während eines Plasmaheizschritts, bei dem Elektronen auf die Werkstücke gezogen werden, oder während eines Plasmaätzschritts, bei dem positive Ionen aus dem Plasma einer Niedervoltbogenentladung auf die Werkstücke gezogen werden, sowie durch isolierende Schichten, die sich während eines Beschichtungsprozesses auf Elektrodenoberflächen niederschlagen können, kann es bei bekannten Vakuumbehandlungsanlagen bzw. Verfahren zu Prozessschwankungen oder auch zu Prozessabbrüchen und Beschädigung von Anlagenkomponenten kommen, da der Stromfluss aus dem Plasma auf kleinere oder über andere, leitfähigere Flächen geleitet oder ganz unterbrochen wird.
Eine weitere Aufgabe der Erfindung ist es, die Abhängigkeit der Plasmabildung weitgehend von der Halterungsgeometrie bzw. dem Einbau zusätzlicher passiver plasmaverstärkender Bauteile unabhängig zu machen. Damit können beispielsweise auch Prozesse zur Behandlung von Werkstücken durch gepulste Glimmentladungen stabil und flexibel betrieben werden. Ein jeweiliges Anpassen der Halterungsgeometrie zur Einhaltung von Dunkelraumabständen ist damit nicht mehr notwendig.
Diese Aufgaben werden erfindungsgemäss durch die Merkmale im kennzeichnenden Teil des Anspruchs 1, bzw. des Anspruches 22 gelöst. In den Unteransprüchen und der folgenden Beschreibung werden entsprechende weitere Ausführungsformen der Erfindung offenbart.
Die Vakuumbehandlungsanlage umfasst zumindest eine Vakuumkammer, in der eine Vorrichtung zur Erzeugung einer elektrischen Niedervoltbogenentladung (NVBE) - hier synonym zum Begriff Niedervoltbogen (NVB) verwendet - bestehend aus einer Kathode und einer mit der Kathode über einen Bogengenerator elektrisch verschaltbaren Anode, angeordnet sind, wobei zumindest ein Teil der Oberfläche der Anode aus Graphit gefertigt ist, um eine hohe Betriebstemperatur, d.h. eine heisse Anode, zu ermöglichen. Weiters befinden sich in der Kammer ein elektrisch mit einem separaten Biasgenerator verschaltbarer Werkstückträger zur Aufnahme und Bewegung von Werkstücken, sowie zumindest eine Zuleitung für Inert- und/oder Reaktivgas.

Für die Gaphitanode kommen dabei unterschiedliche Ausführungsarten in Betracht. Diese kann beispielsweise ganz aus Graphit gefertigt sein, wobei zumindest in unmittelbarer Nähe der Oberfläche keine Kühlvorrichtungen, insbesondere Kühlbohrungen für Kühlmedien, vorgesehen sind, um beispielsweise für die Abscheidung von DLC-Schichten eine Mindestbetriebstemperatur von 200°, bevorzugt 250°C sicherzustellen.

Alternativ kann die Graphitanode lediglich eine Graphitabdeckung umfassen, die als Graphiteinlage bzw. Graphitauflage oder als Graphittiegel ausgebildet ist. In einfacher Weise kann dazu die Graphitabdeckung auf einen bekannten gekühlten Anodenkörper, beispielsweise aus Kupfer, angebracht und somit indirekt gekühlt werden.

Wenn auch für die Abscheidung von DLC-Schichten die mit oben angeführte Anoden durch den Teilchenbeschuss aus der NVBE erreichbaren Temperaturen ausreichen, um eine zumindest teilweise Graphitisierung der Schicht zu erreichen, und damit die Leitfähigkeit der Anode zu erhalten, kann es besonders für die Herstellung anderer schlecht leitender oder isolierender Schichten vorteilhaft sein, die graphitische Oberfläche der Anode zu beheizen oder auf die Kühlung ganz zu verzichten. Die zusätzliche Heizung kann dabei durch bekannte Vorrichtungen beispielsweise durch in der Anode bzw. Graphitabdeckung eingebaute Heizelemente oder durch auf die Graphitoberfläche gerichtete Strahler sichergestellt werden.

Die Anode kann dabei an bzw. in einer Seite der Behandlungsanlage, den Werkstückträger umfassend, oder bevorzugt in der Mitte eines zumindest im Wesentlichen rotationssymetrischen Werkstückhalters angeordnet werden. Zur gleichmässigeren Verteilung des Plasmas in der Vakuumkammer können mehrere Anoden einer Kathode oder mehrere Kathoden einer Anode zugeordnet werden. Letzteres bevorzugt dann, wenn besonders hohe Plasmadichten benötigt werden oder beispielsweise zur Erhöhung der Prozesssicherheit eine Reservekathode vorgesehen wird.

Zusätzlich kann die Vorrichtung zur Erzeugung der Niedervoltbogenentladung axial zu einer oder mehreren elektromagnetischen Spulen zur Erzeugung eines Helmholtzfeldes angeordnet werden. Auch damit lässt sich die Verteilung des Plasmas in der Vakuumkammer beeinflussen, bzw. die Ionisation erhöhen. Beispielsweise kann die NVBE auf die Anode fokussiert und damit beispielsweise die Oberfläche stärker erhitzt oder auch Material aus einem Graphittiegel verdampft werden. Weiters können damit bekannte Verfahren, wie das Heizen bzw. Ätzen der Werkstücke mittels NVB unterstützt werden.

Als Biasgenerator zum Anlegen eines elektrischen Signals an den Werkstückträger und Werkstücke kann ein Wechselstrom, ein bipolarer Pulsgenerator, bevorzugt aber für temperaturempfindliche Werkstücke bzw. Beschichtungsprozesse, ein DC oder unipolarer Pulsgenerator verwendet werden, da bei Letzteren durch den fehlenden Elektronenbeschuss eine geringere thermische Belastung der Werkstücke/Schichten erfolgt.

Als Bogengenerator zur Versorgung der Niedervoltbogenentladung (NVBE) wird ein Hochstrom-DC-Generator, insbesondere ein DC-Generator mit regelbarem Ausgangsstrom verwendet. Zusätzlich kann dazu parallel oder in Reihe zum DC-Generator ein Pulsgenerator geschaltet werden um beispielsweise die Plasmadichte weiter zu erhöhen.

Als Kathode der Niedervoltbogenentladung kann eine Heisskathode mit Glühdraht oder Heizwendel, bevorzugt in einer von der Vakuumkammer durch eine Blende separierten Ionisationskammer, eine NVB-Arckathode oder eine Hohlkathode, bspw. eine Hohlkathode mit Hohlkathoden-Glimmentladung oder eine Elektronenkanone mit Hohlkathodenbogen, verwendet werden.

Alternativ kann die Kathode als NVB-Arckathode ausgebildet sein, die zumindest ein kathodisch geschaltetes Target umfasst, das von der Vakuumkammer, insbesondere von den Werkstücken durch eine Abdeckung optisch getrennt ist.

In den beschriebenen Ausführungen kann die Vakuumbehandlungsanlage als Plasma-CVD und/oder PVD Vakuumbeschichtungsanlage betrieben werden bzw. ausgeführt sein. Für die Durchführung von PE(Plasma Enhanced)-CVD-Prozessen kann die Anlage ohne weitere Modifikationen eingesetzt werden. Um eine optimale Schichtverteilung zu gewährleisten, bzw. unterschiedliche Prozessgase einzuführen, kann es jedoch vorteilhaft sein, eine oder mehrere Gasquellen verteilt im Rezipienten anzuordnen oder ringförmige oder lanzenartige Gaseinlasse zu verwenden.

Für die Durchführung von PVD-Prozessen können in der Vakuumkammer eine oder mehrere Verdampferquellen angeordnet werden. Als Verdampferquellen kommen dabei bevorzugt folgende Vorrichtungen in Frage: Eine Sputterquelle, insbesondere ein Magnetron, eine Arcquelle, insbesondere eine kathodische Arcquelle, einen Elektronenstrahlverdampfer, ein Graphittiegel. Soll beispielsweise lediglich eine Haftschicht aufgedampft oder ein zusätzliches Schichtelement zu der sonst im PE-CVD-Verfahren hergestellten Schicht eingebracht werden, kann beispielsweise ein entsprechendes Material in oben erwähnten anodischen Graphittiegel eingebracht und durch den NVB verdampft werden.

Allgemein kann in der Verdampferquelle folgendes Material zur Verdampfung angeordnet sein: Kohlenstoff, ein Metall oder eine Legierung, insbesondere eine Legierung aus zwei oder mehreren Elemente der IV, V oder VI Gruppe des Periodensystems, sowie Aluminium, Bor oder Silizium, wobei das Material je nach Verdampferquelle als Target, Pellet, Tablette, Draht oder Ähnliches vorliegt.

Soll Graphit von einem Target einer Sputter- oder einer Arcquelle verdampft werden, wird vorteilhaft ein dichter, hochreiner Graphit mit bevorzugt isotroper Struktur verwendet um einen möglichst gleichmässigen Abtrag der Oberfläche zu ermöglichen. Beispielsweise sind Graphitsorten ab einer Dichte von p ≥ 1.8 und einer Reinheitsklasse P30, was einem Aschewert von kleiner 15 ppm entspricht für solche Anwendungen geeignet.

Auf einer wie oben beschriebenen Vakuumbeschichtungsanlage kann auch ein erfindungsgemässes Vakuumbeschichtungsverfahren zur Beschichtung von Werkstücken mit zumindest einer schlecht leitenden, isolierenden und/oder DLC-artigen Schicht durchgeführt werden, wobei die zumindest teilweise aus Graphit bestehende Oberfläche der Anode so erhitzt wird, dass zumindest während des Beschichtungsverfahren eine Abscheidung von isolierenden Schichten verhindert wird und eine ausreichend leitfähige Oberfläche zur Verfügung steht, um einen stabilen Prozessverlauf zu gewährleisten. Dadurch ist es möglich, über die Substratspannung und den Prozessdruck die energetischen Verhältnisse auf der Werkstückoberfläche einzustellen, und gleichzeitig davon elektrisch getrennt eine Niedervoltbogenentladung zur effizienten Zerlegung und Ionisierung des Reaktivgases zu betreiben. Es versteht sich für den Fachmann von selbst, dass ein solches Verfahren auch dann von Vorteil ist, wenn es beispielsweise bei nicht schichtbildenden Plasmaprozessen, beispielsweise bei Ätz- oder Heizprozessen etwa durch Oberflächenreaktion mit Reaktivgas oder Resputtereffekte zu einer isolierenden Belegung der Anodenfläche kommt.

Üblicherweise werden bei PE-CVD- und PVD-Verfahren Ätz- oder Heizprozesse dem Beschichtungsverfahren vorgeschaltet. Dabei zeigte es sich, dass es bei solchen kombinierten Verfahren, bei denen schlecht leitende, isolierende oder DLC-artige Schichten abgeschieden werden, schwierig oder unmöglich ist, eine heisse metallische Anode für einen breiten Bereich unterschiedlicher Niedervoltbogenentladeströme richtig zu dimensionieren. Meist wird für den Heiz- und/oder Ätzprozess ein höherer Entladestrom als bei der Beschichtung verwendet und somit die Anode thermisch viel stärker belastet. Je nach Dimensionierung bzw. Kühlung, kann die metallische Anode daher während der Vorbehandlung zu heiss werden und verdampfen oder sich während der Beschichtungsphase partiell oder vollständig mit einer schlecht leitenden oder isolierenden Schicht belegen. Die Anodenflächen variieren dann und entsprechend variieren auch die Entladeparameter. Eine Balance zwischen schlechter Kühlung und sicherem Verhindern des Verdampfens von Teilen der Anode ist für metallische Anoden schwer einstellbar und reproduzierbar. Überraschend einfach hat sich dagegen für solche Verfahren die Verwendung einer erfindungsgemässen Graphitanode erwiesen, die entweder ungekühlt oder entsprechend grösser und damit schlechter gekühlt ausgeführt wird. Da Graphit auch bei hohen Temperaturen einen sehr kleinen Dampfdruck aufweist, besteht keine Gefahr der Verunreinigung der herzustellenden Schichten.

Die Erhaltung der Leitfähigkeit durch die hohen Oberflächentemperaturen kann dabei je nach Beschichtungsart auf unterschiedliche Vorgänge zurückgeführt werden. Beispielsweise ist für temperaturempfindliche Schichten, die sich auf der heissen Anodenoberfläche zu einem leitenden Schichtbelag zersetzen, oft nicht nötig, dass die Graphitanode glüht. Beispielsweise kann bei der Abscheidung von DLC, insbesondere taC-Schichten die Abscheidung einer isolierender Schicht auf Oberfläche der Anode je nach Prozess (PE-CVD, Sputtern, kathodisches Arcen) bzw. Reaktivgas bereits ab einer Temperatur von 200°C bis höchstens 300°C sicher vermieden werden, da unter diesen Bedingungen offensichtlich eine Graphitisierung der Schicht erfolgt. Hier scheint auch zusätzlich Beschuss der Anode mit hohen Elektronen- bzw. Ionendichten das Aufbrechen von beispielsweise sp² und sp³ Bindungen zu fördern. Mit dieser einfachen Lösung hat es sich gezeigt, dass zum ersten Mal eine DC-Niedervoltbogenentladung für isolierende Schichten stabil betrieben werden konnte.

Überraschenderweise konnte auch nach Beschichtungsprozessen, bei denen nach Erreichen von Raumtemperatur eine isolierende Schicht auf der Graphitanode gemessen wurde, diese ohne umständliches mechanisches Abtragen der Schicht wieder verwendet werden, sofern diese vor Zünden des Niedervoltbogens durch eine zusätzliche, wie oben beschriebene, Heizvorrichtung auf Temperatur gebracht wurde. In diesem Fall musste allerdings eine höhere Oberflächentemperatur auf der Anode eingestellt werden. Im Bereich der beginnenden Rotglut also zwischen 600 bis 700 °C konnte die NVB jedoch verlässlich auch nach Herstellung von hochisolierenden Schichten wie z.B. AlN oder SiN gezündet werden, während 400° C für die meisten Schichten eine Untergrenze darstellt.

Je nach Prozessführung kann Beschichtungsmaterial einzeln, abwechselnd oder gleichzeitig von zumindest einer Gasquelle und zumindest einer Verdampferquelle zugeführt wird.

Aus der Gasquelle können in bekannter Weise Reaktivgase wie Stickstoff, Kohlenwasserstoffe, Silane, Borane, Germane, Stickstoff oder metallorganische Verbindung zur Schichtherstellung ebenso wie Inertgase zugeführt werden, die durch das Plasma der Niedervoltbogenentladung wirkungsvoll zerlegt und ionisiert werden können. Ähnliches gilt für die Möglichkeit das aus einer w.o. beschriebenen Verdampferquelle zugeführte Beschichtungsmaterial zu ionisieren bzw. nachzuionisieren, falls bereits aus der Verdampferquelle ionisierte Teilchen austreten.

Während der Vorbehandlung und/oder während des Beschichtungsprozesse können die elektrischen Versorgungen von Substratspannung, Niedervoltbogen, die Sputter und/oder die Arcquelle jeweils wie erwähnt mit Gleichstrom oder gepulst betrieben werden. Eine zusätzliche Führung der Niedervoltbogenentladung durch ein Magnetfeld, bzw. ein Helmholtzmagnetfeld, erweist sich bei Betreiben einer Niedervoltbogenentladung in der Symmetrieachse der Beschichtungsanlage als vorteilhaft.

Sollen Schichten mit unterschiedlicher Schichtspannung, beispielsweise als Multilayer abgeschieden werden, kann dies durch Variation der Bogenleistung, der Substratspannung und/oder des Magnetfelds erfolgen. Beispielsweise wurden DLC-Multilayer mit von Schichtlage zu Schichtlage jeweils unterschiedlicher Schichtspannung sowohl durch periodisches bzw. aperiodisches Verändern der Substratspannung bzw. des Bogenstroms eingestellt. Beide Massnahmen bewirken eine Änderung des Ionenbeschusses und beeinflussen damit die Fehlstellen und Eigenspannung der Schicht.

Soll die Schicht lediglich aus dem Triodenplasma ohne zusätzliche Verdampferquellen abgeschieden werden, kann dies durch Zuführen zumindest eines Reaktivgases aus der Gruppe der Kohlenwasserstoffe, der Silane, der Germane, der Borane und/oder der metallorganischen Verbindungen geschehen.

Beim Betreiben einer Sputterquelle und/oder einer kathodischen Arcquelle mit einem Target aus Metall, einer Metalllegierungen, einer Metallverbindungen, wie beispielsweise Carbide oder Boride, bzw. aus Graphit, kann die Schichtbildung unter Inertgas erfolgen. Jedoch ist auch hier in vielen Fällen eine zusätzliche oder im Falle eines Arcprozesses sogar ausschliessliche Zufuhr von Reaktivgas zur Schichtbildung möglich bzw. vorteilhaft.

Mit derartigen Verfahren können Mono- oder Multilagenschichten die zumindest eine Lage eines der folgenden Materialien umfassen abgeschieden werden: ein Carbid, ein Carbonitrid, ein Nitrid, ein Borid, ein Borkarbid, ein Bornitrid, und deren Verbindungen mit bevorzugt zumindest einem Übergangsmetall aus der IV, V, VI Gruppe des Periodensystem und/oder Aluminium bzw. Silizium. Beispiele derartiger Schichten sind keramische bzw. metallkeramische Schichten wie SiN, AlN, Ge₃N₄, (AlCrSi)N, (AlCrMe{=Metal})N, (AlCrSiMe)N, (TiSi)N, hBN, cBN, BCN, TiBC und andere. Weiters können diese Schichten auch Sauerstoff wie etwa (AlCrSi)CNO, (AlCrSi)NO enthalten, sofern der Prozess nicht unter einem zu hohen Sauerstoffpartialdruck geführt wird, der zu einer Schädigung der Graphitoberfläche der Anode führen könnte.

Die Übergänge zwischen den einzelnen Schichtlagen können dabei prinzipiell beliebig ausgeführt werden, jedoch wird in vielen Fällen aus bekannten Gründen ein fliessender Übergang durch stufenweises oder kontinuierliches Verändern der Prozessparameter wie beispielsweise Gasfluss, Partialdruck des Reaktivgases, Verdampferquellenleistung, Bogenleistung, Substratspannung etc. zu bevorzugen sein.

Auch DLC-Schichten können bei Anlegen einer w.o. beschriebenen Substratspannung, allein durch Zuführen zumindest eines Reaktivgases, in diesem Fall eines Kohlenwasserstoffs, in das Plasma der NVBE hergestellt werden. Will man besonders harte oder wasserstoffarme DLC-Schichten, etwa ta-C-Schichten herstellen, ist ein Verfahren unter Verwendung einer Sputter-und/oder einer kathodischen Arcquelle jeweils mit einem Graphittarget vorteilhaft. Überraschenderweise kann auch hier, wie unten gezeigt, durch Zufuhr zumindest eines Kohlenwasserstoffs die Schichthärte gegenüber dem Betrieb im reinen Inertgasplasma gesteigert werden.

Zur Verbesserung der Haftfähigkeit bzw. zur Verringerung allzu grosser Schichtspannungen kann die DLC-Schicht mit einer metall- oder siliziumhaltigen Haftschicht bzw. mit zumindest einer metall- oder siliziumhaltigen Zwischenschicht als Multilagenschicht abgeschieden wird.

Sollen verschiedene Schichteigenschaften wie zum Beispiel ausgzeichnete Haftfestigkeit und Zähigkeit metallhaltiger Schichten mit den besonders guten Gleiteigenschaften bzw. Härte von DLC-Schichten kombiniert werden, kann beispielsweise zunächst wie oben beschrieben eine Schicht bestehend aus einem Carbid, einem Carbonitrid, einem Nitrid, einem Borid, einem Borkarbid oder einem Bornitrid auf einem Werkstück aufgebracht und dieses anschliessend mit einer w.o. beschriebene DLC-Schicht überbeschichtet werden.

### Kurze Beschreibung der Zeichnungen

Im Folgenden wird die Erfindung anhand von Figuren, welche lediglich verschiedene Ausführungsbeispiele darstellen, näher erläutert. Es zeigen
- Figur 1: eine Vakuumbeschichtungsanlage mit Anode nach dem Stand der Technik
- Figur 2: eine entsprechende Anode mit Graphitauflage
- Figur 3: eine entsprechende Anode mit Graphiteinlage
- Figur 4: eine Vakuumbeschichtungsanlage mit zwei Graphitanoden
- Figur 5: ein Prozessdiagramm
- Figur 6: eine DLC-Schicht mit Cr/CrC - Gradientenschicht
- Figur 7: eine DLC-Schicht mit DLC/SiC - Mehrlagenschicht

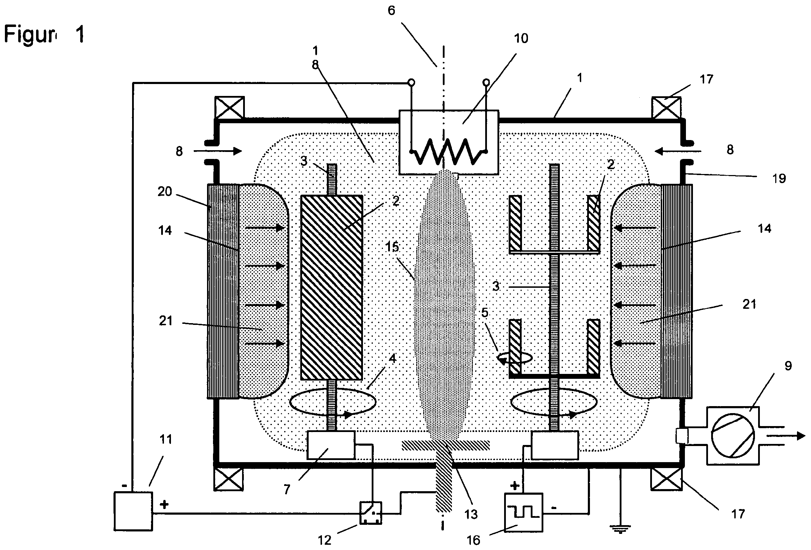

Figur 1 zeigt eine Vakuumbeschichtungsanlage mit einer Anode nach dem Stand der Technik. In der Vakuumkammer 1 sind die zu beschichtenden Werkstücke 2 auf einer bzw. mehreren Werkstückaufnahmen 3 montiert, die Mittel zur Erzeugung einer zumindest einfachen, bei Bedarf auch zweifachen 4 oder dreifachen 5 Rotation der Teile umfasst. Dabei werden die Werkstückaufnahmen 3 häufig auf einem zusätzlich um die Anlagenachse 6 drehbaren Werkstückträger 7 positioniert.

Über Gaszuleitungen 8 können die unterschiedlichen Prozessgase in die Vakuumkammer 1 mittels geeigneter, hier nicht dargestellter Regelvorrichtungen zugeführt werden.
Ein hochvakuumtauglicher Pumpstand 9 ist an die Kammer angeflanscht.

Eine Ionen- und /oder Elektronenquelle, insbesondere eine NVB-Kathode 10 ist beispielsweise im Bereich der Anlagenachse angeordnet und an den negativen Ausgang eines Bogengenerators 11 angeschlossen. Der positive Pol des Bogengenerators 11 kann je nach Prozessschritt über einen Schalter 12 an den Werkstückträger 7 bzw. an die Werkstückaufnahme 3 und die damit elektrisch verbundenen Werkstücke 2 (Heizprozess) oder an die NVB-Anode 13 (bei Ätzprozess, bzw. bei Bedarf auch während der Beschichtungsprozesse) angelegt werden.

An den Wänden der Vakuumkammer 1 kann eine oder mehrere Verdampferquellen 14, bevorzugt ein Magnetron oder ein Lichtbogenverdampfer vorgesehen sein. In einer anderen, hier nicht dargestellten Ausführungsform der Verdampferquelle 14 kann diese als anodisch geschalteter Tiegel zentral im Boden der Vakuumkammer 1 angebracht sein. Dabei wird das Verdampfungsgut mittels Erhitzen durch den Niedervoltbogen 15 in die Gasphase übergeführt.

Ferner ist ein zusätzlicher elektrischer Biasgenerator 16 vorgesehen, mit dessen Hilfe an die Werkstücke eine Substratspannung angelegt werden kann.

Weiters können elektromagnetische Spulen 17 zur Erzeugung eines longitudinalen, den Plasmaraum durchdringenden Magnetfelds, eines so genannten Helmholtzfeldes, an gegenüberliegenden Begrenzungswänden der Vakuumkammer 1 angeordnet und durch mindestens eine, vorzugsweise zwei getrennte, hier nicht näher dargestellte DC-Spannungsquellen vorzugsweise gleichsinnig gespeist werden.

Als zusätzliche Massnahmen zur Verstärkung bzw. gleichmässigeren Ausformung des Magnetfelds und beispielsweise eines durch einen MF-Biasgenerator erzeugtes MF-Plasmas 18 können an den Seitenwänden 19 der Vakuumkammer 1, Magnetsysteme zur Ausbildung mehrerer magnetischer Nahfelder 21 angebracht werden. Bevorzugt werden in diesem Fall die Magnetsysteme für die Nahfelderzeugung zumindest teilweise als Magnetronmagnetsysteme 20 ausgebildet.

Die einzelnen Systeme der Beschichtungsanlage werden vorteilhafterweise durch eine hier nicht näher dargestellte Prozesssteuerung miteinander in Beziehung gesetzt.

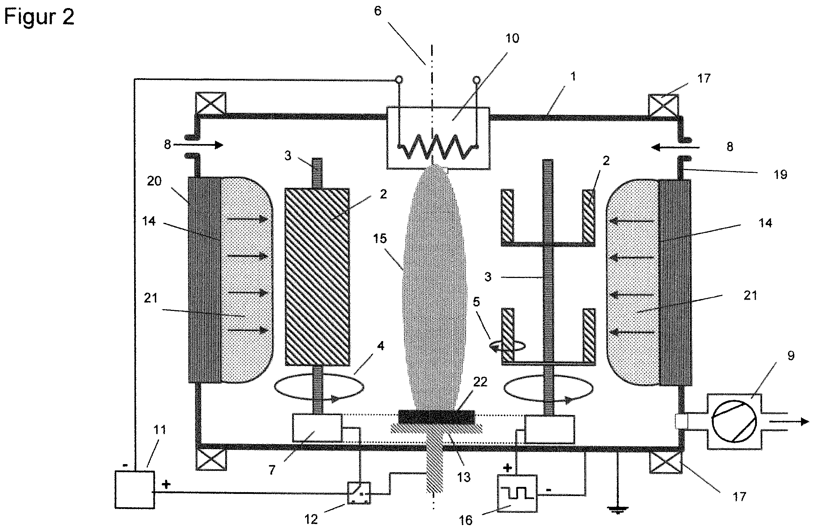

Figur 2 zeigt eine erfindungsgemässe Vakuumbeschichtungsanlage mit einer einfachen Graphitanode, bei der auf eine bekannte flache Kupferanode eine Graphitabdeckung 22 in Form einer Graphitscheibe aufgelegt ist.

Da die Plasmadichten im Niedevoltbogen 15 und in dessen unmittelbarer Nähe sehr hoch sind, ist es aber auch notwendig, die Werkstücke 2 vor elektrischen Überschlägen zu schützen. Dies kann durch Wahl einer geeigneten Substratspannung geschehen. Aus diesem Grunde empfiehlt es sich auch nicht, bei hohen Entladeströmen mit einer bipolaren Substratspannung zu arbeiten, vor allem dann, wenn hohe Substratspannungen realisiert werden sollen. Der Grund dafür ist, dass beim bipolaren Biaspulsbetrieb während der positiven Spannungsintervalle sehr hohe E-lektronenströme auf das Werkstück gezogen werden können. Das führt, zumindest bei DLC und taC, zum unerwünschten Aufheizen des Werkstücks, aber auch zu vermehrten Überschlägen auf das Werkstück. Viel schonender ist die Benutzung einer unipolar gepulsten Substratspannung, die es den Elektronen aus dem Niedervoltbogen in den Pausen gestattet, die durch die positiven Ionen aufgebaute Oberflächenladung wieder zu entladen. In den Pulspausen kann das Werkstück dabei geerdet oder auch floatend betrieben werden, wobei letzteres noch schonender ist. Das Puls-Pausen-Verhältnis sollte aber frei gestaltet werden können und es sollte während des Prozesses veränderlich sein, wie auch die Substratspannung.

Wichtig ist in diesem Zusammenhang, dass man auch den Energieeintrag am Werkstück 2 durch eine Änderung der Entladeparameter des Niedervoltbogens 15 ändern kann, also beispielsweise für konstante Substratspannung kann der Substratstrom und damit die Substratleistung verändert werden, indem der Entladestrom vergrössert oder verkleinert wird. Diese Methode kann auch wie oben erwähnt für Multilayerstrukturen in einem Schichtmaterial von identischer chemischer Zusammensetzung verwendet werden, um beispielsweise den Stress in dicken Schichten abzubauen und gute Schichthaftung zu erzielen.

Der Niedervoltbogen 15 kann dabei auf zwei verschiedene Arten gestaltet sein: wie in den Figuren dargestellt als Linearquelle, wenn die äusseren Spulen 17 zur Fokussierung verwendet werden, oder als diffuses Plasma, das über die ganze Prozesskammer verteilt ist, so dass die Werkstücke 2 in das Plasma eintauchen.

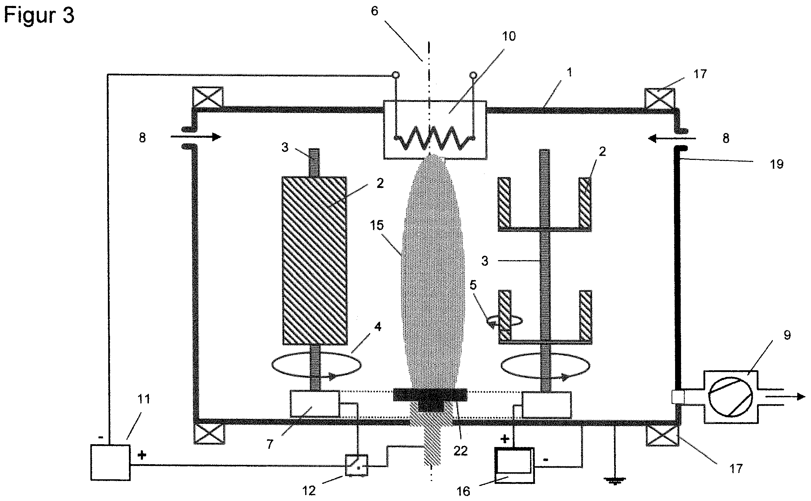

Figur 3 zeigt eine erfindungsgemässe Vakuumbehandlungsanlage, die aber auch als Vakuumbeschichtungsanlage für PE-CVD Prozesse betrieben werden kann. In dieser Ausführung ist die Graphitanode als Graphiteinlage 22, die in einem bekannten gekühlten Kupfertiegel aufgelegt ist, ausgeführt. Letztere kann wiederum ihrerseits als Graphittiegel ausgeführt sein, um beispielsweise vor der Beschichtung mit einer mittels PE-CVD hergestellten Schicht eine Haftschicht durch Einbringen von Metalltabletten oder Ähnlichem in einfacher Weise aufbringen zu können. Weiters wird in Figur 3 ein DC-Biasgenerator 16 verwendet.

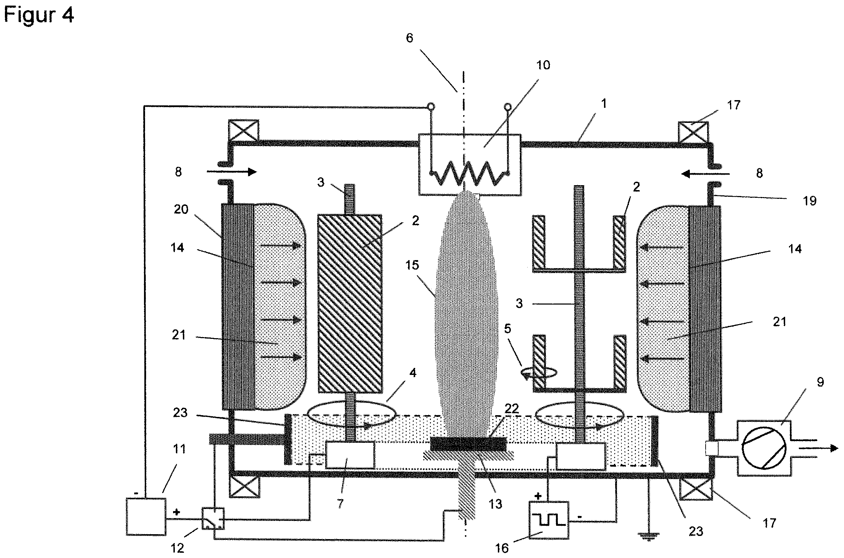

In Figur 4 zeigt eine erfindungsgemässe Vakuumbeschichtungsanlage mit Graphitanode 13, bei der zwei NVB-Anoden 13 und 23 angeordnet sind. Beispielsweise kann über den Schalter 12 der positive Ausgang des Bogengenerators abwechselnd oder gleichzeitig mit der NVB-Graphitanode 13, 22 bzw. der in diesem Fall ringförmigen NVB-Graphitanode 22 verbunden werden. Durch die Zuschaltung der NVB-Ringanode 23 wird es ähnlich wie beim Betrieb ohne Magnetspulen möglich, das Plasma diffus über die Anlagenkammer 1 zu verteilen. Es versteht sich für den Fachmann von selbst, dass diese beiden Möglichkeiten zur Optimierung einer gleichmässigen NVB-Plasmaverteilung optimiert werden können.

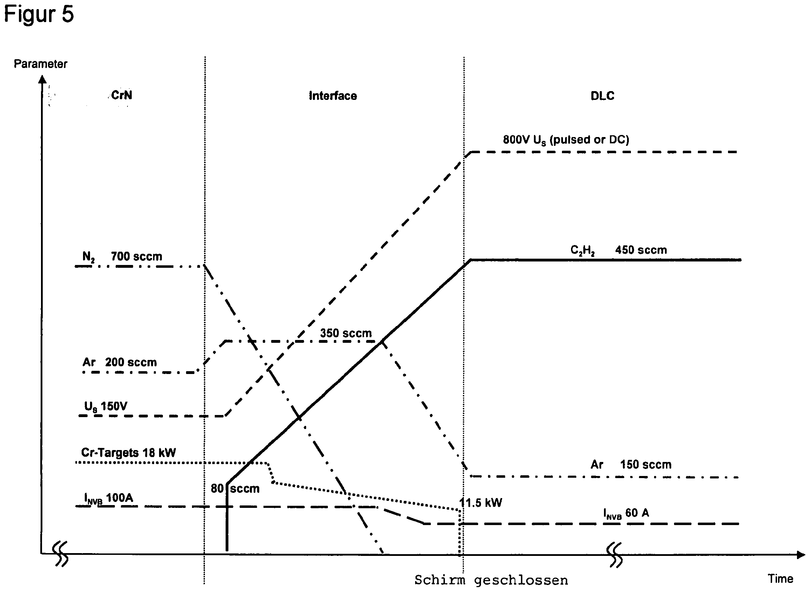

Figur 5 beschreibt beispielhaft den Verlauf der Prozessparameter bei der Herstellung einer kombinierten CrN-DLC-Schicht mit dazwischenliegendem Interface, innerhalb dessen die Eigenschaften der zwei unterschiedlichen Schichtsysteme im Wesentlichen kontinuierlich aneinander angepasst werden. Dabei wird zunächst in einem PVD-Verfahren, beispielsweise durch einen Sputter- bzw. Arcprozess, eine CrN-Schicht erzeugt, anschliessend während der Herstellung der Interface-Schicht zusätzlich ein PE-CVD-Prozess hochgefahren und gleichzeitig Targetleistung und Stickstoffzufluss auf Null verringert. Im letzten Prozesschritt, der auch ohne vorgeschaltete Zwischenschicht oder Interface direkt auf die Oberfläche eines Werkstücks angewandt werden kann, werden hier konstante Prozessparameter zur Herstellung einer über die Schichtdicke isomorphen DLC-Schicht verwendet.

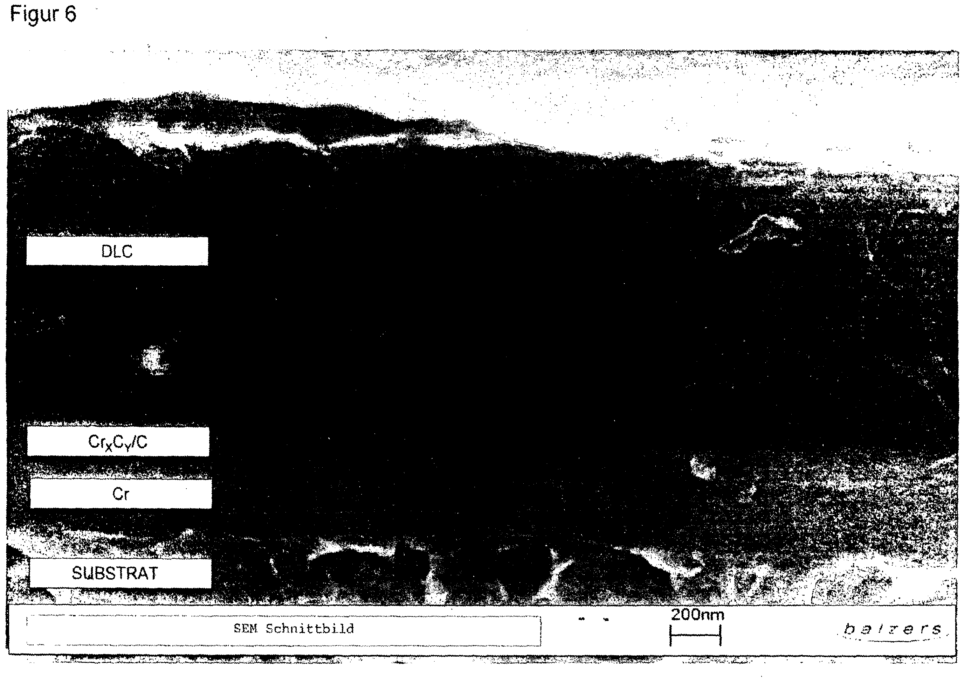

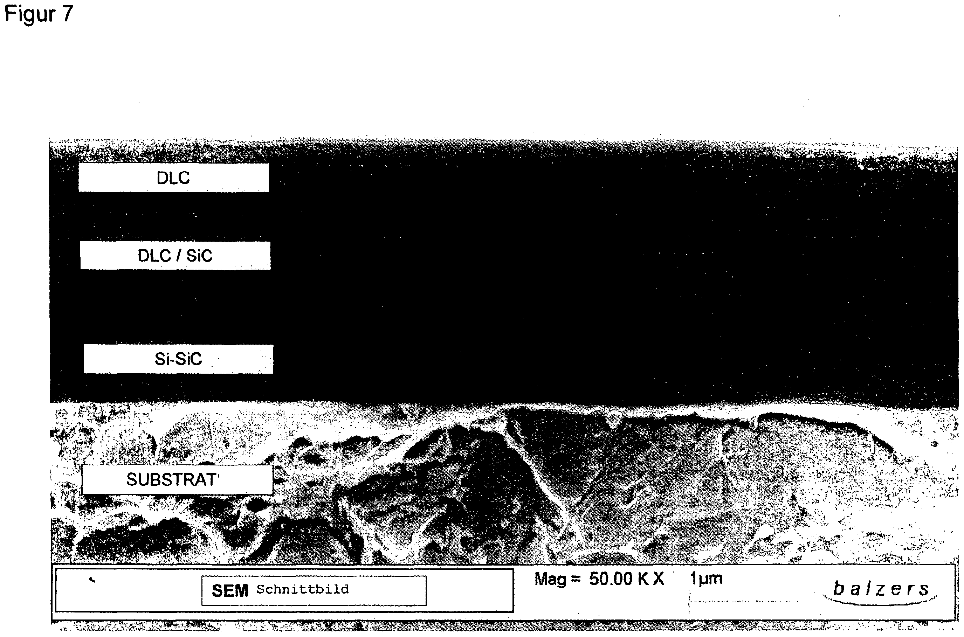

Figur 6 zeigt eine REM-Aufnahme der Bruchfläche einer ähnlich wie in Figur 5 hergestellten Mehrlagenschicht mit einer Chrom Haftschicht, gradierter Interface-Schicht und DLC-Deckschicht. Figur 7 zeigt eine nach Verfahrensbeispiel 2 abgeschiedene Multilagenschicht aus einer Abfolge unterschiedlicher SiC- und DLC-Schichten.

### Wege zur Ausführung der Erfindung

Im Folgenden werden verschiedene Beispiele zum Ablauf erfindungsgemässer Verfahren beschrieben.

Die Beispiele 1 bis 3, in denen Verfahren zur Abscheidung Sihaltiger DLC-Schichten beschrieben werden, wurden auf einer modifizierten RCS-Anlage der Firma OC Oerlikon Balzers AG vorgenommen, wobei auf eine gekühlte Kupferanode eine Graphitabdeckung in Form einer Scheibe aufgelegt wurde. Damit konnte auf äusserst einfache Weise bereits ein ausreichender elektrischer Übergang hergestellt werden. Gleichzeitig wurde die Kühlung der Graphitoberfläche gegenüber der ursprünglichen Kupferanode deutlich herabgesetzt, womit die Leitfähigkeit der Oberfläche auch während des Beschichtungsrozesses erhalten bleibt.

Beispiel 1) Prozess zur Herstellung von DLC mit einer Zwischenschicht aus Si/SiC.

Nach Einlegen der Werkstücke in die dafür vorgesehenen zwei-oder dreifach rotierbaren Halterungen und Einbringen der Halterungen in die Vakuumbehandlungsanlage, wird die Behandlungskammer auf einen Druck von ca. 10⁻⁴ mbar abgepumpt.

Zur Einstellung der Prozesstemperatur wird ein Niedervoltbogen(NVB)-Plasma zwischen einer durch eine Lochblende abgetrennten Kathodenkammer mit Heisskathode, die die NVB-Kathode bildet, und den anodisch geschalteten Werkstücken in einer Argon-Wasserstoffatmosphäre gezündet. Die an den Werkstücken anliegende Substratspannung wird dabei bevorzugt zusätzlich unipolar oder bipolar gepulst. Die Standardstrahlungsheizer wurden in diesem Beispiel nicht verwendet.

Der Heizprozess basierte auf folgenden Parametern:

| | |
|---|---|
| Entladestrom des NVB: | 50 A |
| Argonfluss: | 60 sccm |
| Wasserstofffluss: | 300 sccm |
| Prozesszeit: | 20 min |

Als nächster Prozessschritt wird das Ätzen gestartet. Dafür wird der Niedervoltbogen zwischen dem Filament und der Graphitanode betrieben. Prinzipiell kann hier eine DC, eine gepulste DC oder eine mit Wechselstrom betriebene MF oder RF Versorgung zwischen Werkstücken und Masse geschaltet werden. Für das vorliegende Verfahren wurde ein zweistufiger Ätzprozess mit folgenden Ätzparametern eingestellt:

**1. Schritt:**

| | |
|---|---|
| Argonfluss: | 65 sccm |
| Wasserstofffluss: | 80 sccm |
| Entladestrom des NVB: | 100 A |
| Substratspannung | - 50 V unipolar (100 µs on/10 µs off) |
| Prozesszeit: | 15 Min |

**2. Schritt:**

| | |
|---|---|
| Argonfluss: | 65 sccm |
| Wasserstofffluss: | 80 sccm |
| Entladestrom des NVB: | 100 A |
| Substratspannung | - 200 V unipolar (100 µs on/10 µs off) |
| Prozesszeit: | 30 Min |

Im nächsten Prozessschritt erfolgt die Beschichtung des Werkstückes mit einer DLC-Schicht und einer Si-SiC-Zwischenschicht zur Haftvermittlung und Anpassung der Schichteigenschaften an den Substratwerkstoff. Für die Beschichtung wird der Niedervoltbogen betrieben. Der Entladestrom des Niedervoltbogens wird dabei gegen die Graphitanode gezogen. Die Parameter der Niedervoltbogenentladung, die während des gesamten Beschichtungsprozesses läuft, sind:

| | |
|---|---|
| Entladestrom des NVB: | 40 A |
| Argonfluss: | 60 sccm |

Für die einzelnen Schritte des Beschichtungsprozesses wurden zusätzlich folgende Parameter eingestellt:

**Si Haftschicht:**

| | |
|---|---|
| Silanfluss: | 30 sccm |
| Substratspannung: | - 600 V unipolar (10 µs on/10 µs off) |
| Zeitdauer: | 3 min |

**SiC Übergangsschicht**

| | |
|---|---|
| Silanfluss: | lineare Rampe von 30 sccm auf 10 sccm |
| C₂H₂-Fluss: | lineare Rampe von 15 sccm auf 120 sccm |
| Substratspannung: | - 600 V unipolar (10 µs on/10 µs off) |
| Zeitdauer: | 30 min |

**DLC-Funktionsschicht:**

| | |
|---|---|
| C₂H₂-Fluss: | 120 sccm |
| Prozessdruck: | 0.36 Pa |
| Substratspannung: | - 600 V unipolar (10 µs on/10 µs off) |
| Zeitdauer: | 30 min |

Auf diese Art wurde eine Schicht von ca. 1.5 µm abgeschieden. Die Temperatur des Werkstückes erreichte ca. 290°C.

Beispiel 2) Bei diesem Prozess wurde auf den Heizschritt verzichtet, dafür ein verlängerter Ätzschritt verwendet. Wieder wird der Niedervoltbogen analog zum vorherigen Beispiel zwischen dem Filament und der Gaphitanode betrieben und die Werkstücke mit einer unipolar gepulsten negativen Substratspannung beaufschlagt. Dabei wurden folgende Ätzparameter eingestellt:

**1. Schritt:**

| | |
|---|---|
| Argonfluss: | 65 sccm |
| Wasserstofffluss: | 80 sccm |
| Entladestrom des NVB: | 50 A |
| Bias | - 50 V unip. (100 µs on/10 µs off) |
| Prozesszeit: | 25 Min |

**2. Schritt:**

| | |
|---|---|
| Argonfluss: | 65 sccm |
| Wasserstofffluss: | 80 sccm |
| Entladestrom des NVB: | 100 A |
| Bias | - 150 V unip. (100 µs on/10 µs off) |
| Prozesszeit: | 60 Min |

Im nächsten Prozessschritt erfolgt die Beschichtung des Werkstückes mit einer DLC-SiC-Multilagenschicht und einer Si-SiN-SiC-Zwischenschicht. Für die Beschichtung wird der Entladestrom des Niedervoltbogens gegen die Graphitanode gezogen. Die Parameter der Niedervoltbogenentladung werden wie in Beispiel 1 eingestellt.

Für die einzelnen Schritte des Beschichtungsprozesses wurden zusätzlich folgende Parameter eingestellt:

**Si Haftschicht:**

| | |
|---|---|
| Silanfluss: | 30 sccm |
| Substratspannung: | - 600 V unipolar (10 µs on/10 µs off) |
| Zeitdauer: | 3 min |

**SiN Übergangsschicht:**

| | |
|---|---|
| Silanfluss: | 30 sccm |
| N₂-Fluss: | lineare Rampe von 15 sccm auf 120 sccm |
| Substratspannung: | - 600 V unipolar (10 µs on/10 µs off) |
| Zeitdauer: | 15 min |

**SiC Übergangsschicht:**

| | |
|---|---|
| Silanfluss: | lineare Rampe von 30 sccm auf 10 sccm |
| N₂-Fluss: | lineare Rampe von 120 sccm auf 0 sccm (innert 5 min) |
| C₂H₂-Fluss: | lineare Rampe von 15 sccm auf 120 sccm |
| Substratspannung: | - 600 V unipolar (10 µs on/10 µs off) |
| Zeitdauer: | 15 min |

**DLC-SiC-Multilayer-Funktionsschicht:**

| | |
|---|---|
| C₂H₂-Fluss: | 120 sccm (für jeweils 5 min) |
| Silanfluss: | 30 sccm (mit C₂H₂ w.o. für jeweils 5 min) |
| Prozessdruck: | 0.3 Pa (C2H2) bzw. 0.47 Pa (C2H2 + SiH4) |
| Substratspannung: | - 600 V unipolar (10 µs on/10 µs off) |
| Zeitdauer: | 60 min |

Auf diese Art wurde eine Gesamtschichtdicke auf Werkstücken mit zweifacher Rotation von ca. 1.5 µm erreicht. Die Temperatur des Werkstückes erreichte ca. 180°C.

Beispiel 3) Bei diesem Prozess wurde wie in Beispiel 2 auf den Heizschritt verzichtet und dafür ein verlängerter Ätzschritt verwendet.

Im nächsten Prozessschritt erfolgt die Beschichtung des Werkstückes mit einer Si-SiC-Zwischenschicht, gefolgt von einer DLC-Si-Multilagenschicht und einer abschliessenden DLC-Schicht. Für die Beschichtung wird der Niedervoltbogen wie in Beispiel 1 betrieben.

Für die einzelnen Schritte des Beschichtungsprozesses wurden zusätzlich folgende Parameter eingestellt:

**Si Haftschicht:**

| | |
|---|---|
| Silanfluss: | 30 sccm |
| Substratspannung: | - 600 V unipolar (10 µs on/10 µs off) |
| Zeitdauer: | 3 min |

**SiC Übergangsschicht:**

| | |
|---|---|
| Silanfluss: | lineare Rampe von 30 sccm auf 10 sccm |
| C₂H₂-Fluss: | lineare Rampe von 15 sccm auf 120 sccm |
| Substratspannung: | - 600 V unipolar (10 µs on/10 µs off) |
| Zeitdauer: | 30 min |

**DLC-SiC-Multilayer-Funktionsschicht:**

| | |
|---|---|
| C₂H₂-Fluss: | 120 sccm (für jeweils 5 min) |
| Silanfluss: | 30 sccm (mit C₂H₂ w.o. für jeweils 5 min) |
| Prozessdruck: | 0.3 Pa (C2H2) bzw. 0.43 Pa (C2H2 + SiH4) |
| Substratspannung: | - 600 V unipolar (10 µs on/10 µs off) |
| Zeitdauer: | 60 min |

**Für die DLC-Schicht:**

| | |
|---|---|
| C₂H₂-Fluss: | 120 sccm |
| Substratspannung: | - 800 V unipolar (10 µs on/10 µs off) |
| Prozessdruck: | 0.3 Pa |
| Zeitdauer: | 30 min |

Auf diese Art wurde eine Gesamtschichtdicke auf Werkstücken mit zweifacher Rotation von ca. 2 µm erreicht (siehe Figur 7). Die Temperatur des Werkstückes erreichte ca. 180°C.

Die Beispiele 4 bis 8, in denen Verfahren zur Abscheidung von DLC-Schichten beschrieben werden, wurden auf einer modifizierten BAI830DLC-Anlage der Firma OC Oerlikon Balzers AG vorgenommen. Auch bei Beispielen 5 bis 6 wurde auf eine gekühlte Kupferanode lediglich eine Graphitabdeckung in Form einer Scheibe aufgelegt. Die Werkstücke wurden dabei zweifach rotierend in einem Abstand von 60-175 mm zum Target, bei einer Beladungshöhe von 10-1000 mm geführt. Detaillierte Angaben zu den jeweiligen Prozessparametern sowie den damit erzielten Schichteigenschaften finden sich in Tabelle 1.

Beispiel 4) Bei diesem Beispiel handelt es sich zum einen bekannten Prozess für Vergleichszwecke. Dabei wird nach einer Heiz- bzw. Ätzvorbehandlung bei einem Prozessdruck zwischen 5. 0x10-³ - 2.0x10⁻² mbar eine Glimmentladung zwischen Werkstückaufnahmen und Kesselwand, wie bereits in EP01362931 bzw. WO2006-116889A1 beschrieben, gezündet und betrieben. Die Werkstückaufnahmen sind so ausgelegt, dass im inneren eine das Glimmentladungsplasma verstärkende Hohlkathodenentladung brennt. Alternativ können auch andere elektrisch leitende Hohlkörper zur Plasmaverstärkung verwendet werden, solange bestimmte aus WO2006-116889A1 bekannte geometrische Bedingungen eingehalten werden.

Beispiel 5) und Beispiel 7) Bei diesen erfindungsgemässen Beispielen wird eine Niedervoltbogenentladung auf eine in der Mitte eines Werkstückhalters angebrachten Graphitanode analog Figur 2 gezündet und während der ganzen Prozessfolge von Heizen, Ätzen und Beschichten aufrechterhalten. Für das DLC-Beschichten werden zwei bzw. sechs mit Graphittargets bestückte Sputterquellen zugeschaltet, während am Werkstück ein DC Bias von hundert Volt angelegt ist. Es wurde kein Kohlenwasserstoffgas zugeführt. Durch die geringere Spannung wird auch keine Hohlentladung in einer Halterung oder einem entsprechend gebauten Hohlkörper gezündet. Die Plasmaentladung ist damit in einem weit geringeren Ausmass von der Geometrie der Einbauten insbesondere des Werkstückträgers und der Werkstückaufnahmen abhängig.

Beispiel 6) und Beispiel 8) bei diesen ebenfalls erfindungsgemässen Beispielen wird der Prozess ähnlich zu Beispielen 5 und 7 mit zwei bzw. sechs Sputtertargets geführt, wobei aber zusätzlich noch eine geringe Menge eines Kohlenwasserstoffgases zugeführt wird. Auffallend ist, dass es damit gelingt die Schichthärte gegenüber rein gesputterten Schichten um den Faktor drei bis vier und damit auch die Verschleissbeständigkeit um ein Vielfaches zu erhöhen.

Trotz der geringen Härte der ohne Kohlenwasserstoffgas abgeschiedenen Schichten aus Beispielen 5 und 7, können diese Schichten vorteilhaft angewandt werden, beispielsweise um die Einlaufeigenschaften und/oder Gleiteigenschaften einer harten Schicht zu verbessern. Besonders einfach lässt sich ein derartiges Schichtsystem beispielsweise durch eine Kombination der Schichten aus Beispielen 6 bzw. 8 mit darauf abgeschiedenen Schichten nach Beispielen 5 bzw. 7 verwirklichen.
Eine andere Möglichkeit ist es, in oben erwähnten Sputterprozessen statt DC-Sputtern, eine AC oder eine gepulste Sputterquelle, beispielsweise auch als Zwillingsquelle, bei der zwei Sputtertargets mit den gegenpoligen Ausgängen eines bipolaren Pulsgenerators vebunden sind zu betreiben. Weiters kann auch eine oder mehrere mit einem entsprechend ausgelegten Sputtergenerator verbundene Quellen auch im so genannte HI-PIMS(High Ionisation Puls Impact Magnetron Sputtering)-Verfahren betrieben werden, wobei an die entsprechende Quelle je nach gewünschtem Leistungseintrag bzw. Target- und Schichttyp vorteilhaft ein Pulssignal innerhalb der folgenden Parameterbereiche angelegt wird:

| | |
|---|---|
| Pulsbreite: | 10 µs bis 100 ms |
| Pulsspannung: | 100 V bis 2 kV |
| Pulsstrom: | 10 A bis 1.5 kA |
| Pulsleistung: | 5 - 50 kW |

**Tabelle 1**

| | Bsp.4 St.d.T. | Bsp.5 | Bsp.6 | Bsp.7 | Bsp.8 |
|---|---|---|---|---|---|
| C₂H₂ [sccm] | 220-350 | 0 | 10-25 | 0 | 10-50 |
| Ar [sccm] | 30 - 50 | 90 | 90 | 115 | 115 |
| Pₜₒₜ [10⁻³ mbar] | 5.0-20 | 3.5 | 2.9-3.0 | 3.2 | 3.2-3.5 |
| I_{NVB} [A] | keine | 30 | 30 | 30 | 30 |
| Sputterquellen | keine | 2 | 2 | 6 | 6 |
| U_{substrat} Puls [V] | 800-1000 | - | - | - | - |
| U_{substrat} DC [V] | - | 100 | 50/100 | 100 | 50/100/1 50 |
| I_{Substrat} [A] | 0.5-1A | 0.A | 0.8-1.4 | 0.8 | 0.6-1.0 |
| r_{deposit} [µm/h] | 0.2-0.5 | 0.1 | 0.2-0.6 | 0.8 | 0.6-1.0 |
| T_{Substrate} [°C] | 200-290 | 220 | 200-240 | 270 | 210-270 |
| H [At%_{]}¹⁾ | 13 - 17 | 5 | 12 - 17 | 5 | 11 - 15 |
| Schichthärte²⁾ [HIT] | 18.500-31.000 | 4.700 | 13.700-31.000 | 4.500 | 9.500-30.900 |
| Haftung³⁾ | HF 1-2 | HF 1-2 | HF 1-2 | HF 1-2 | HF 1-2 |
| Verschleiss⁴⁾ [m³ m⁻¹ N⁻¹ 10⁻¹⁵] | 0.7-1.0 | > 6 | 0.9-5.8 | > 6 | 0.4-2.5 |
| Ra / Rz⁵⁾ [µm] | | 0.023 / 0.33 | .015-.033 / .16-.42 | .084 / 1.48 | .027-.058 / .34-.87 |

| | | | | | |
|---|---|---|---|---|---|
| ¹⁾ Wasserstoffgehalt mittels SIMS gemessen ²⁾ HIT-Mikroschichthärte nach ISO 14577-1 ³⁾ Haftung nach VDI 3198 ⁴⁾ Verschleisstest nach Normentwurf DIN EN 1071-6:2006-01 zur Bestimmung des Abriebwiderstands von Schichten ⁵⁾ Rauhigkeit Ra, Rz nach DIN EN ISO 4287/88 | | | | | |

### Bezugszeichenliste

- 1: Vakuumkammer
- 2: Werkstück
- 3: Werkstückaufnahme
- 4: zweifache Rotation
- 5: dreifache Rotation
- 6: Anlagenachse
- 7: Werkstückträger
- 8: Gaszuleitung
- 9: Pumpstand
- 10: NVB-Kathode
- 11: Bogengenerator
- 12: Schalter
- 13: NVB-Anode
- 14: Verdampferquelle
- 15: Niedervoltbogen (NVB)
- 16: Biasgenerator
- 17: elektromagnetische Spule
- 18: MF-Plasma
- 19: Kammerwand
- 20: Magnetsystem
- 21: Magnetisches Nahfeld
- 22: Graphitabdeckung
- 23: ringförmige NVB-Anode

## Patentansprüche

1. Vakuumbehandlungsanlage zur Durchführung eines Plasmaverfahrens, wobei die Behandlungsanlage zumindest eine Vakuumkammer (1) umfasst, in der eine Vorrichtung zur Erzeugung einer elektrischen Niedervoltbogenentladung (15) (NVBE), bestehend aus einer Kathode (10) und einer mit der Kathode (10) über einen Bogengenerator elektrisch verschaltbaren Anode (13), und ein elektrisch mit einem Biasgenerator (16) verschaltbarer Werkstückträger (7) zur Aufnahme und Bewegung von Werkstücken (2), sowie zumindest eine Zuleitung (8) für Inert- und/oder Reaktivgas angeordnet sind, **dadurch gekennzeichnet, dass** zumindest ein Teil der Oberfläche der Anode (13) aus Graphit gefertigt ist, wobei die Anode (13) eine Graphitabdeckung (22) umfasst.

2. Vakuumbehandlungsanlage gemäss Anspruch 1, **dadurch gekennzeichnet, dass** die Graphitabdeckung als Graphiteinlage, Graphitauflage oder als Graphittiegel ausgebildet ist.

3. Vakuumbehandlungsanlage nach einem der Ansprüche 1 bis 2, **dadurch gekennzeichnet, dass** die Graphitabdeckung auf einem gekühlten Anodenkörper angeordnet ist.

4. Vakuumbehandlungsanlage nach einem der An-sprüche 1 bis 2, **dadurch gekennzeichnet, dass** die Anode (13) nicht oder nur indirekt gekühlt ist, oder in unmittelbarer Nähe der Anodenoberfläche keine Kühlvorrichtungen, insbesondere keine Kühlbohrungen für Kühlmedien, vorgesehen sind.

5. Vakuumbehandlungsanlage nach einem der Ansprüche 1 bis 2, **dadurch gekennzeichnet, dass** zumindest ein Teil der Graphitoberfläche der Anode (13) beheizbar ist.

6. Vakuumbehandlungsanlage nach einem der vorhergehenden Ansprüche, **dadurch gekennzeichnet, dass** die Anode (13) an bzw. in einer Seite der Behandlungsanlage, oder den Werkstückträger umfassend, oder bevorzugt in der Mitte eines rotationssymetrischen Werkstückhalters angeordnet ist.

7. Vakuumbehandlungsanlage nach einem der vorhergehenden Ansprüche, **dadurch gekennzeichnet, dass** zumindest zwei Anoden einer Kathode zugeordnet sind.

8. Vakuumbehandlungsanlage nach einem der vorhergehenden Ansprüche, **dadurch gekennzeichnet, dass** zumindest zwei Kathoden einer Anode zugeordnet sind.

9. Vakuumbehandlungsanlage nach einem der vorhergehenden Ansprüche, **dadurch gekennzeichnet, dass** der Biasgenerator (16) ein DC-, ein Wechselstrom- oder ein unipolarer bzw. bipolarer Pulsgenerator ist.

10. Vakuumbehandlungsanlage nach einem der vorhergehenden Ansprüche, **dadurch gekennzeichnet, dass** der Bogengenerator (16) ein DC-Generator, insbesondere ein DC-Generator mit variabel regelbarem Ausgangsstrom ist.

11. Vakuumbehandlungsanlage nach Anspruch 10, **dadurch gekennzeichnet, dass** parallel oder in Reihe zum DC-Generator ein Pulsgenerator geschaltet ist.

12. Vakuumbehandlungsanlage nach einem der vorhergehenden Ansprüche, **dadurch gekennzeichnet, dass** die Kathode (10) der Niedervoltbogenentladung eine Heisskathode, eine NVB-Arckathode oder eine Hohlkathode ist.

13. Vakuumbehandlungsanlage nach Anspruch 12, **dadurch gekennzeichnet, dass** die Heisskathode zumindest einen Glühdraht, bevorzugt eine Heizwendel, umfasst, der in einer von der Vakuumkammer durch eine Blende separierten Ionisationskammer angeordnet ist.

14. Vakuumbehandlungsanlage nach Anspruch 12, **dadurch gekennzeichnet, dass** die NVB-Arckathode zumindest ein kathodisch geschaltetes Target umfasst, das von der Vakuumkammer, insbesondere von den Werkstücken (2) durch eine Abdeckung optisch getrennt ist.

15. Vakuumbehandlungsanlage nach einem der vorhergehenden Ansprüche, **dadurch gekennzeichnet, dass** die Vorrichtung zur Erzeugung der Niedervoltbogenentladung axial zu einer oder mehreren elektromagnetischen Spulen zur Erzeugung eines Helmholtzfeldes angeordnet ist.

16. Vakuumbehandlungsanlage nach einem der vorhergehenden Ansprüche **dadurch gekennzeichnet, dass**, die Behandlungsanlage eine Vakuumbeschichtungsanlage zur Durchführung eines Plasma-CVD und/oder eines PVD Verfahrens zur Abscheidung schlecht leitender, isolierender und/oder DLC-artiger Schichten ist.

17. Vakuumbehandlungsanlage nach Anspruch 16, **dadurch gekennzeichnet, dass** in der Vakuumkammer eine oder mehrere Verdampferquellen angeordnet sind.

18. Vakuumbehandlungsanlage nach Anspruch 17, **dadurch gekennzeichnet, dass** die Verdampferquelle eine der folgenden Vorrichtungen umfasst: Eine Sputterquelle, insbesondere ein Magnetron, eine Arcquelle, insbesondere eine kathodische Arcquelle, einen Elektronenstrahlverdampfer, einen Graphittiegel.

19. Vakuumbehandlungsanlage nach einem der Ansprüche 17 bis 18, **dadurch gekennzeichnet, dass** in der Verdampferquelle folgendes Material zur Verdampfung angeordnet ist: Kohlenstoff, ein Metall oder eine Legierung, insbesondere eine Legierung aus zwei oder mehreren Elemente der IV, V oder VI Gruppe des Periodensystems, sowie Aluminium, Bor oder Silizium.

20. Vakuumbehandlungsanlage nach einem der Ansprüche 17 bis 19, **dadurch gekennzeichnet, dass** das Material zur Verdampfung als Target vorliegt.

21. Vakuumbehandlungsanlage nach einem der Ansprüche 17 bis 20, **dadurch gekennzeichnet, dass** das Material zur Verdampfung ein dichter, hochreiner Graphit mit bevorzugt isotroper Struktur ist.

22. Vakuumbehandlungsverfahren zur Plasmabehandlung von Werkstücken, wobei in einer Vakuumkammer (1) einer Behandlungsanlage eine elektrische Niedervoltbogenentladung (NVBE) zwischen einer Kathode (10) und einer mit der Kathode (10) über einen Bogengenerator elektrisch verbunden Anode (13) gezündet und betrieben wird, während an den Werkstücken (2) eine Substratspannung mit einem Biasgenerator angelegt und Prozessgas von zumindest einer Gasquelle zugeführt wird, **dadurch gekennzeichnet, dass** eine heisse Anode (13) verwendet wird, deren Oberfläche zumindest teilweise aus Graphit besteht, wobei die Anode eine Graphitabdeckung umfasst.

23. Vakuumbehandlungsverfahren nach Anspruch 22, **dadurch gekennzeichnet, dass** das Behandlungsverfahren zumindest einen der folgenden Schritte umfasst: Plasmauntestütztes Heizen, Ätzen oder Beschichten.

24. Vakuumbehandlungsverfahren nach einem der Ansprüche 22 und 23, **dadurch gekennzeichnet, dass** zumindest ein Teil der Graphitoberfläche der Anode (13) so beheizt wird, dass die Temperatur der beheizten Graphitoberfläche auf eine Temperatur ansteigt, die die Leitfähigkeit der Anode (13) erhält und/oder eine Abscheidung Isolierbelegungen und/oder von isolierenden Schichten verhindert.

25. Vakuumbehandlungsverfahren nach einem der Ansprüche 22 bis 24, **dadurch gekennzeichnet, dass** die Niedervoltbogenentladung durch ein Magnetfeld, bevorzugt durch ein Helmholtzmagnetfeld, geführt wird.

26. Vakuumbehandlungsverfahren nach einem der Ansprüche 22 bis 25, **dadurch gekennzeichnet, dass** das Behandlungsverfahren ein Vakuumbeschichtungsverfahren zur Beschichtung von Werkstücken mit zumindest einer schlecht leitenden, isolierenden und/oder DLC-artigen Schicht ist.

27. Vakuumbehandlungsverfahren nach Anspruch 26, **dadurch gekennzeichnet, dass** Beschichtungsmaterial von zumindest einer Gasquelle und/oder zumindest einer Verdampferquelle zugeführt wird.

28. Vakuumbehandlungsverfahren nach Anspruch 27, **dadurch gekennzeichnet, dass** das von der Verdampferquelle zugeführte Beschichtungsmaterial aus der Entladung einer Sputterquelle, insbesondere eines Magnetrons, aus der Entladung einer Arcquelle, insbesondere einer kathodische Arcquelle, aus dem Dampf eines Elektronenstrarhlverdampfers, oder aus dem Dampf eines aus einem Graphittiegel mittels einer Niedervoltbogenentladung verdampften Materials stammt.

29. Vakuumbehandlungsverfahren nach einem der Ansprüche 27 bis 28, **dadurch gekennzeichnet, dass** die Schicht durch Betreiben einer Sputterquelle und/oder einer kathodischen Arcquelle mit zumindest einem Target aus zumindest einem der Materialien aus der Gruppe der Metalle, der Metalllegierungen, der Metallverbindungen, bzw. aus Graphit, bevorzugt unter Zufuhr von Reaktivgas abgeschieden wird.

30. Vakuumbehandlungsverfahren nach einem der Ansprüche 27 bis 29, **dadurch gekennzeichnet, dass** die Schicht durch Zuführen zumindest eines Reaktivgases aus der Gruppe der Kohlenwasserstoffe, der Silane, der Borane, der Germane und/oder der metallorganischen Verbindungen abgeschieden wird.

31. Vakuumbehandlungsverfahren nach einem der Ansprüche 26 bis 30, **dadurch gekennzeichnet, dass** die Substratspannung, der Niedervoltbogen und/oder die Verdampferquelle gepulst betrieben wird.

32. Vakuumbehandlungsverfahren nach Anspruch 31, **dadurch gekennzeichnet, dass** eine bipolar gepulste Substratspannung mit im Verhältnis zu den negativen Pulsen kurzen positiven Pulsen, oder bevorzugt eine unipolar gepulst Substratspannung angelegt wird.

33. Vakuumbehandlungsverfahren nach einem der Ansprüche 26 bis 32, **dadurch gekennzeichnet, dass** durch Variation der Bogenleistung, der Substratspannung und/oder des Magnetfelds Schichten unterschiedlicher Schichtspannung, bevorzugt als Multilayer, hergestellt werden.

34. Vakuumbehandlungsverfahren nach einem der Ansprüche 26 bis 33, **dadurch gekennzeichnet, dass** eine Schicht die zumindest eine Lage eines der folgenden Materialien umfasst abgeschieden wird: Ein Carbid, ein Carbonitrid, ein Nitrid, ein Borid, ein Borkarbid, ein Bornitrid, bevorzugt in Verbindung mit zumindest einem Übergangsmetall aus der IV, V, VI Gruppe des Periodensystem, Aluminium und/oder Silizium.

35. Vakuumbehandlungsverfahren nach einem der Ansprüche 26 bis 34, **dadurch gekennzeichnet, dass** die Schicht als Multilagenschicht unterschiedlicher Zusammensetzung abgeschieden wird, wobei die Übergänge zwischen den einzelnen Schichtlagen bevorzugt fliessend ausgeführt werden.

36. Vakuumbehandlungsverfahren nach einem der Ansprüche 26 bis 35, **dadurch gekennzeichnet, dass** durch Zuführen zumindest eines Kohlenwasserstoffs über die Gasquelle zumindest eine DLC-Schicht abgeschieden wird.

37. Vakuumbehandlungsverfahren nach einem der Ansprüche 26 bis 36, **dadurch gekennzeichnet, dass** durch Betreiben einer Sputterquelle und/oder einer kathodischen Arcquelle mit einem Graphittarget, zumindest eine DLC-Schicht abgeschieden wird.

38. Vakuumbehandlungsverfahren nach einem der Ansprüche 36 bis 37, **dadurch gekennzeichnet, dass** die DLC-Schicht mit einer metall- oder siliziumhaltigen Haftschicht und/oder mit zumindest einer metall- oder siliziumhaltigen Zwischenschicht als Multilagenschicht abgeschieden wird.

39. Vakuumbehandlungsverfahren nach einem der Ansprüche 36 bis 38, **dadurch gekennzeichnet, dass** zumindest die Graphitoberfläche der Anode (13) auf eine Temperatur von 200, bevorzugt 250°C erwärmt wird, um die Abscheidung von isolierenden DLC-Schichten zu verhindern.

40. Vakuumbehandlungsverfahren nach einem der Ansprüche 36 bis 39, **dadurch gekennzeichnet, dass** zumindest ein Teil der DLC-Schicht als Multilagenschicht mit Lagen unterschiedlicher Schichtspannung abgeschieden wird.

41. Vakuumbehandlungsverfahren nach einem der Ansprüche 36 bis 40, **dadurch gekennzeichnet, dass** zunächst eine Schicht nach einem Verfahren gemäss Ansprüchen 34 bis 35 auf dem Werkstück (2) und anschliessend eine weiter Schicht nach einem Verfahren gemäss Ansprüchen 36 bis 40 abgelegt wird.

## Claims

1. Vacuum treatment plant for performing a plasma method, wherein the treatment plant comprises at least one vacuum chamber (1) in which an apparatus for generating an electric low voltage arc discharge (15) (NVBE) is arranged, consisting of a cathode (10) and an anode (13) being electrically interconnectable to the cathode (10) via an arc generator, and a workpiece carrier (7) for receiving and moving workpieces (2), is the workpiece carrier being electrically interconnectable to a bias generator (16), as well as at least one feed line (8) for inert and/or reactive gas, **characterized in that** at least part of the surface of the anode (13) is made of graphite, wherein the anode (13) comprises a graphite cover (22).

2. Vacuum treatment plant according to claim 1, **characterized in that** the graphite cover is configured as a graphite inlay, graphite overlay or graphite crucible.

3. Vacuum treatment plant according to one of the claims 1 to 2, **characterized in that** the graphite cover is arranged on a cooled anode body.

4. Vacuum treatment plant according to one of the claims 1 to 2, **characterized in that** the anode (13) is not cooled or cooled only indirectly, or no cooling apparatuses are provided in the immediate proximity of the anode surface, in particular no cooling boreholes for cooling media.

5. Vacuum treatment plant according to one of the claims 1 to 2, **characterized in that** at least a portion of the graphite surface of the anode (13) can be heated.

6. Vacuum treatment plant according to one of the preceding claims, **characterized in that** the anode (13) is arranged at or in a side of the treatment plant, or comprises the workpiece carrier, or is arranged preferably in the centre of a rotationally symmetric workpiece holder.

7. Vacuum treatment plant according to one of the preceding claims, **characterized in that** at least two anodes are associated with one cathode.

8. Vacuum treatment plant according to one of the preceding claims, **characterized in that** at least two cathodes are associated with one anode.

9. Vacuum treatment plant according to one of the preceding claims, **characterized in that** the bias generator (16) is a DC, an AC or a unipolar or bipolar pulse generator.

10. Vacuum treatment plant according to one of the preceding claims, **characterized in that** the arc generator (16) is a DC generator, in particular a DC generator with variably controllable output current.

11. Vacuum treatment plant according to claim 10, **characterized in that** a pulse generator is connected in parallel or in series with the DC generator.

12. Vacuum treatment plant according to one of the preceding claims, **characterized in that** the cathode (10) of the low voltage arc discharge is a hot cathode, a NVB arc cathode or a hollow cathode.

13. Vacuum treatment plant according to claim 12, **characterized in that** the hot cathode comprises at least one glow filament, preferably a heating coil, which is arranged in an ionisation chamber separated from the vacuum chamber by a baffle.

14. Vacuum treatment plant according to claim 12, **characterized in that** the NVB arc cathode comprises at least one cathodically connected target, which is optically separated from the vacuum chamber, in particular from the workpieces (2), by a cover.

15. Vacuum treatment plant according to one of the preceding claims, **characterized in that** the apparatus for generating the low voltage arc discharge is arranged axially relative to one or several electromagnetic coils for generating a Helmholtz field.

16. Vacuum treatment plant according to one of the preceding claims, **characterized in that** the treatment plant is a vacuum coating plant for performing a plasma CVD and/or a PVD method for the deposition of poorly conducting, insulating and or DLC-like layers.

17. Vacuum treatment plant according to claim 16, **characterized in that** one or several evaporator sources are arranged in the vacuum chamber.

18. Vacuum treatment plant according to claim 17, **characterized in that** the evaporator source comprises one of the following apparatuses: a sputter source, in particular a magnetron, an arc source, in particular a cathodic arc source, an electron beam evaporator, a graphite crucible.

19. Vacuum treatment plant according to one of the claims 17 to 18, **characterized in that** the following material is arranged for evaporation in the evaporator source: carbon, a metal or an alloy, in particular an alloy of two or more of the elements of the IV, V or VI group of the periodic table, as well as aluminium, boron or silicon.

20. Vacuum treatment plant according to one of the claims 17 to 19, **characterized in that** the material for evaporation is present as the target.

21. Vacuum treatment plant according to one of the claims 17 to 20, **characterized in that** the material for evaporation is a dense, highly pure graphite of preferably isotropic structure.

22. Vacuum treatment method for plasma treatment of workpieces, wherein in Vacuum chamber (1) of a treatment plant an electrical low voltage arc discharge (NVBE) is ignited and operated between a cathode (10) and an anode (13) electrically connected to the cathode (10) via an arc generator, while a substrate voltage is applied to the workpieces (2) by a bias generator and process gas from at least one gas source is supplied, **characterized in that** a hot anode (13) is used whose surface consists at least partly of graphite, wherein the anode comprises a graphite cover.

23. Vacuum treatment method according to claim 22, **characterized in that** the treatment method comprises at least one of the following steps: plasma-supported heating, etching or coating.

24. Vacuum treatment method according to one of the claims 22 and 23, **characterized in that** at least a part of the graphite surface of the anode (13) is heated in such a way that the temperature of the heated graphite surface rises to a temperature which maintains the conductivity of the anode (13) and/or prevents the deposition of insulating coats and/or of insulating layers.

25. Vacuum treatment method according to one of the claims 22 to 24, **characterized in that** the low voltage arc discharge is guided by a magnetic field, preferably by a Helmholtz magnetic field.

26. Vacuum treatment method according to one of the claims 22 to 25, **characterized in that** the treatment method is Vacuum coating method for the coating of workpieces with at least one poorly conducting, insulating and/or DLC-like layer.

27. Vacuum treatment method according to claim 26, **characterized in that** the coating material is supplied from at least one gas source and/or at least one evaporator source.

28. Vacuum treatment method according to claim 27, **characterized in that** the coating material supplied from the evaporator source originates from the discharge of a sputter source, in particular a magnetron, from the discharge of an arc source, in particular a cathodic arc source, from the vapour of an electronic beam evaporator, or from the vapour of a material vaporised from a graphite crucible by means of a low voltage arc discharge.

29. Vacuum treatment method according to one of the claims 27 to 28, **characterized in that** the layer is deposited by operating a sputter source and/or a cathodic arc source with at least one target from at least one of the materials from the group of metals, metal alloys, metal compounds, or of graphite, preferably with a support of reactive gas.

30. Vacuum treatment method according to one of the claims 27 to 29, **characterized in that** the layer is deposited by supplying at least one reactive gas from the group of hydrocarbons, silanes, boranes, germanes and/or metallo-organic compounds.

31. Vacuum treatment method according to one of the claims 26 to 30, **characterized in that** the substrate voltage, the low voltage arc and/or the evaporator source is pulse-operated.

32. Vacuum treatment method according to claim 31, **characterized in that** a bipolar pulsed substrate voltage is applied with positive pulses which are short in comparison with the negative pulses, or preferably a unipolar pulsed substrate voltage.

33. Vacuum treatment method according to one of the claims 26 to 32, **characterized in that** layers of different layer stress, preferably configured as multilayers, are produced by variation of the arc power, the substrate voltage and/or the magnetic field.

34. Vacuum treatment method according to one of the claims 26 to 33, **characterized in that** a coating is deposited which comprises at least one layer of one of the following materials: a carbide, a carbonitride, a nitride, a boride, a boron carbide, a boron nitride, preferably in connection with at least one transition metal from the group IV, V or VI of the periodic table, aluminium and/or silicon.

35. Vacuum treatment method according to one of the claims 26 to 34, **characterized in that** the layer is deposited as a multilayered layer of different composition, wherein the transitions between the individual layers are preferably performed in a smooth manner.

36. Vacuum treatment method according to one of the claims 26 to 35, **characterized in that** at least one DLC layer is deposited by supplying at least one hydrocarbon via the gas source.

37. Vacuum treatment method according to one of the claims 26 to 36, **characterized in that** at least one DLC layer is deposited by operating a sputter source and/or a cathodic arc source with a graphite target.

38. Vacuum treatment method according to one of the claims 36 to 37, **characterized in that** the DLC layer is deposited with a metal- or silicon-containing adhesion layer and/or with at least one metal- or silicon-containing intermediate layer as multilayered layer.

39. Vacuum treatment method according to one of the claims 36 to 38, **characterized in that** the at least the graphite surface of the anode (13) is heated to a temperature of 200°C, preferably 250°C, in order to prevent the deposition of insulating DLC layers.

40. Vacuum treatment method according to one of the claims 36 to 39, **characterized in that** at least a portion of the DLC layer is deposited as multilayered layer with layers of different layer stress.

41. Vacuum treatment method according to one of the claims 36 to 40, **characterized in that** first a layer is deposited on the workpiece (2) according to a method according to claims 34 to 35 and subsequently a further layer is deposited according to a method according to claims 36 to 40.

## Revendications

1. Installation de traitement sous vide pour réaliser un procédé au plasma, l'installation de traitement sous vide comprenant au moins une chambre à vide (1), dans laquelle se trouvent un dispositif destiné à produire un arc électrique de décharge basse tension (15) (NVBE) et comprenant une cathode (10) et une anode (13) pouvant être connectée électriquement à la cathode (10) par un générateur d'arc, un support de pièce (7) pouvant être connecté électriquement à un générateur de polarisation (16) destiné à recevoir et à déplacer des pièces (2), ainsi qu'au moins une conduite d'amenée (8) destinée à un gaz inerte et/ou réactif, **caractérisée en ce qu'**au moins une partie de la surface de l'anode (13) est réalisée en graphite, l'anode (13) comprenant un revêtement en graphite (22).

2. Installation de traitement sous vide selon la revendication 1, **caractérisée en ce que** le revêtement en graphite est réalisé sous la forme d'un revêtement intérieur en graphite, d'un dépôt de graphite ou d'un creuset en graphite.

3. Installation de traitement sous vide selon l'une des revendications 1 à 2, **caractérisée en ce que** le revêtement en graphite est agencé sur un corps d'anode refroidi.

4. Installation de traitement sous vide selon l'une des revendications 1 à 2, **caractérisée en ce que** l'anode (13) n'est pas refroidie ou bien uniquement de façon indirecte, ou **en ce qu'**il n'est pas prévu à proximité immédiate de la surface d'anode de dispositifs de refroidissement, en particulier de trou de refroidissement pour des liquides de refroidissement.

5. Installation de traitement sous vide selon l'une des revendications 1 à 2, **caractérisée en ce qu'**au moins une partie de la surface en graphite de l'anode (13) peut être chauffée.

6. Installation de traitement sous vide selon l'une des revendications précédentes, **caractérisée en ce que** l'anode (13) est agencée au niveau de ou sur un côté de l'installation de traitement, ou bien en englobant le support de pièces, ou de façon préférée au milieu d'un cadre support de pièces symétrique en rotation.

7. Installation de traitement sous vide selon l'une des revendications précédentes, **caractérisée en ce qu'**il est associé au moins deux anodes à une cathode.

8. Installation de traitement sous vide selon l'une des revendications précédentes, **caractérisée en ce qu'**il est associé au moins deux cathodes à une anode.

9. Installation de traitement sous vide selon l'une des revendications précédentes, **caractérisée en ce que** le générateur de polarisation (16) est un générateur DC, un générateur à courant alternatif, ou bien un générateur d'impulsions unipolaire ou bipolaire.

10. Installation de traitement sous vide selon l'une des revendications précédentes, **caractérisée en ce que** le générateur d'arc (16) est un générateur DC, en particulier un générateur DC avec un courant de sortie à réglage variable.

11. Installation de traitement sous vide selon la revendication 10, **caractérisée en ce qu'**un générateur d'impulsions est connecté en parallèle ou en série par rapport au générateur DC.

12. Installation de traitement sous vide selon l'une des revendications précédentes, **caractérisée en ce que** la cathode (10) de l'arc électrique de décharge basse tension est une cathode chaude, une cathode d'arc NVB ou une cathode creuse.

13. Installation de traitement sous vide selon la revendication 12, **caractérisée en ce que** la cathode chaude comprend au moins un filament chauffant, de préférence un serpentin chauffant qui est agencé dans une chambre d'ionisation séparée de la chambre à vide par un obturateur.

14. Installation de traitement sous vide selon la revendication 12, **caractérisée en ce que** la cathode d'arc NVB comprend au moins une cible montée en cathode qui est séparée visuellement de la chambre à vide, en particulier des pièces (2), par un cache.

15. Installation de traitement sous vide selon l'une des revendications précédentes, **caractérisée en ce que** le dispositif destiné à produire l'arc de décharge basse tension est agencé axialement à une ou plusieurs bobines électromagnétiques destinées à produire un champ de Helmholtz.

16. Installation de traitement sous vide selon l'une des revendications précédentes, **caractérisée en ce que** l'installation de traitement est une installation de revêtement sous vide destinée à réaliser un procédé plasma-CVD et/ou un procédé PVD pour déposer des couches peu conductrices, des couches isolantes et/ou des couches de type DLC.

17. Installation de traitement sous vide selon la revendication 16, **caractérisée en ce qu'**il est agencé dans la chambre à vide une ou plusieurs sources de vaporisation.

18. Installation de traitement sous vide selon la revendication 17, **caractérisée en ce que** la source de vaporisation comprend un des dispositifs suivants : une source de pulvérisation, en particulier un magnétron, une source d'arc, en particulier une source d'arc cathodique, un vaporisateur à faisceau d'électrons, un creuset en graphite.

19. Installation de traitement sous vide selon l'une des revendications 17 à 18, **caractérisée en ce qu'**il est agencé dans la source de vaporisation les matières suivantes pour la vaporisation : du carbone, un métal ou un alliage, en particulier un alliage de deux éléments ou plus du groupe IV, V ou VI du tableau périodique, ainsi que de l'aluminium, du bore ou du silicium.

20. Installation de traitement sous vide selon l'une des revendications 17 à 19, **caractérisée en ce que** la matière pour la vaporisation se présente sous forme de cible.

21. Installation de traitement sous vide selon l'une des revendications 17 à 20, **caractérisée en ce que** la matière pour la vaporisation est un graphite dense très pur avec de préférence une structure isotrope.

22. Procédé de traitement sous vide pour traiter au plasma des pièces, dans lequel on allume et on active dans une chambre à vide (1) d'une installation de traitement un arc électrique de décharge basse tension (NVBE) entre une cathode (10) et une anode (13) raccordée électriquement à la cathode (10) par le biais d'un générateur d'arc, tout en appliquant sur les pièces (2) une tension de substrat avec un générateur de polarisation et en introduisant un gaz de traitement d'au moins une source de gaz, **caractérisé en ce qu'**on utilise une anode chaude (13) dont la surface est composée au moins en partie de graphite, l'anode comprenant un revêtement en graphite.

23. Procédé de traitement sous vide selon la revendication 22, **caractérisé en ce que** le procédé de traitement comprend au moins l'une des étapes suivantes : chauffage au plasma, gravure ou enrobage.

24. Procédé de traitement sous vide selon l'une des revendications 22 et 23, **caractérisé en ce qu'**au moins une partie de la surface de graphite de l'anode (13) est chauffée de telle sorte que la température de la surface de graphite chauffée monte à une température qui conserve la conductivité de l'anode (13) et/ou empêche une séparation des revêtements isolants et/ou des couches isolantes.

25. Procédé de traitement sous vide selon l'une des revendications 22 à 24, **caractérisé en ce que** l'arc électrique de décharge basse tension est réalisé par un champ magnétique, de préférence par un champ magnétique de Helmholtz.

26. Procédé de traitement sous vide selon l'une des revendications 22 à 25, **caractérisé en ce que** le procédé de traitement est un procédé de revêtement sous vide pour revêtir des pièces d'au moins une couche peu conductrice, isolante et/ou de type DLC.

27. Procédé de traitement sous vide selon la revendication 26, **caractérisé en ce que** la matière de revêtement est amenée par au moins une source de gaz et/ou au moins une source de vaporisation.

28. Procédé de traitement sous vide selon la revendication 27, **caractérisé en ce que** la matière de revêtement amenée par la source de vaporisation provient de la décharge d'une source de pulvérisation, en particulier d'un magnétron, de la décharge d'une source d'arc, en particulier d'une source d'arc cathodique, de la vapeur d'un vaporisateur à faisceau d'électrons, ou bien de la vapeur d'une matière vaporisée depuis un creuset de graphite à l'aide d'un arc de décharge basse tension.

29. Procédé de traitement sous vide selon l'une des revendications 27 à 28, **caractérisé en ce que** la couche est déposée à l'aide d'une source de pulvérisation et/ou d'une source d'arc cathodique avec au moins une cible composée d'au moins une des matières issues du groupe des métaux, des alliages métalliques, des composés métalliques, ou de graphite, de préférence avec apport de gaz réactif.

30. Procédé de traitement sous vide selon l'une des revendications 27 à 29, **caractérisé en ce que** la couche est déposée par introduction d'au moins un gaz réactif issu du groupe des hydrocarbures, des silanes, des boranes, des germanes et/ou des composés métallo-organiques.

31. Procédé de traitement sous vide selon l'une des revendications 26 à 30, **caractérisé en ce que** la tension de substrat, l'arc basse tension et/ou la source de vaporisation est pulsé(e).

32. Procédé de traitement sous vide selon la revendication 31, **caractérisé en ce qu'**il est appliqué une tension de substrat pulsée bipolaire avec de courtes impulsions positives par rapport aux impulsions négatives, ou bien de préférence une tension de substrat pulsée unipolaire.

33. Procédé de traitement sous vide selon l'une des revendications 26 à 32, **caractérisé en ce qu'**en variant la puissance d'arc, la tension de substrat et/ou le champ magnétique, on produit des couches de tension de couche différente, de préférence sous forme de multicouches.

34. Procédé de traitement sous vide selon l'une des revendications 26 à 33, **caractérisé en ce qu'**il est dépose une couche comprenant au moins une couche de l'une des matières suivantes : un carbure, un carbonitrure, un nitrure, un borure, un carbure de bore, un nitrure de bore, de préférence en liaison avec au moins un métal de transition issu du groupe IV, V, VI du tableau périodique, un aluminium et/ou un silicium.

35. Procédé de traitement sous vide selon l'une des revendications 26 à 34, **caractérisé en ce que** la couche est déposée sous la forme d'une couche à plusieurs couches de composition différente, les transitions entre les différentes couches étant de préférence fluides.

36. Procédé de traitement sous vide selon l'une des revendications 26 à 35, **caractérisé en ce qu'**en introduisant au moins un hydrocarbure via la source de gaz, on dépose au moins une couche DLC.

37. Procédé de traitement sous vide selon l'une des revendications 26 à 36, **caractérisé en ce qu'**en utilisant une source de pulvérisation et/ou une source d'arc cathodique avec une cible graphite, on dépose au moins une couche DLC.

38. Procédé de traitement sous vide selon l'une des revendications 36 à 37, **caractérisé en ce que** la couche DLC est déposée sous la forme d'une couche multiple avec une couche adhésive contenant du métal ou du silicium et/ou avec au moins une couche intermédiaire contenant du métal ou du silicium.

39. Procédé de traitement sous vide selon l'une des revendications 36 à 38, **caractérisé en ce qu'**au moins la surface de graphite de l'anode (13) est chauffée à une température de 200, de préférence 250°C, pour éviter la séparation des couches isolantes DLC.

40. Procédé de traitement sous vide selon l'une des revendications 36 à 39, **caractérisé en ce qu'**au moins une partie de la couche DLC est déposée sous la forme d'une couche à couches multiples avec des couches de tension de couche différente.

41. Procédé de traitement sous vide selon l'une des revendications 36 à 40, **caractérisé en ce qu'**on dépose d'abord sur la pièce (2) une couche suivant le procédé selon les revendications 34 à 35 et **en ce qu'**on dépose ensuite une autre couche selon un procédé selon les revendications 36 à 40.
